# EUROPEAN PATENT APPLICATION

(11) **EP 1 522 891 A1**
(43) Date of publication of application: **13.04.2005**
(21) Application number: 04023911.3
(22) Date of filing: 07.10.2004
(51) Int. Cl.: G03F 7/004, G03F 7/039

(54) **Positive resist composition and pattern forming method using the same**

(30) Priority: 08.10.2003 JP 2003349022
(71) Applicant: FUJI PHOTO FILM CO., LTD., Kanagawa 250-01 (JP)
(72) Inventor: Takahashi, Hyou, Yoshida-cho Haibara-gu Shizuoka (JP)
(74) Representative: HOFFMANN - EITLE

(57) **Abstract**

A positive resist composition comprising: (A) a resin which increases a solubility of the resin (A) in an alkali developer by an action of an acid; (B-1) a triarylsulfonium salt having a fluorine atom in a cation part of the triarylsulfonium salt, wherein the triarylsulfonium salt generates one of: an aliphatic sulfonic acid having a fluorine atom; and an aromatic sulfonic acid having a fluorine atom upon irradiation with one of an actinic ray and a radiation; (C) anitrogen-containingbasiccompound; and (D) an organic solvent, and pattern forming method using the same.

## Description

### Background of the Invention

### 1. Field of the Invention

The present invention relates to a positive resist composition to be employed in a process for producing a semiconductor device such as an IC, a process for producing a circuit board for a liquid crystal display or a thermal head, and other photofabrication processes, and a pattern forming method using the same.

### 2. Description of the Related Art

A resist composition is a pattern forming material which generates an acid in an exposed area upon irradiation with an actinic ray or a radiation, and differentiating a solubility to a developer between an area irradiated with the actinic ray or the radiation and a non-irradiated area by a reaction catalyzed by such acid, thereby forming a pattern on a substrate.

As an acid generating agent for generating an acid upon irradiation with an actinic ray or a radiation, a triarylsulfonium salt having a fluorine atom is described, for example, in WO 02/092559A1 and JP-A No. 2000-258902.

However, for conventional resist compositions, further improvements have been desired in a resolution, a sensitivity, an initial particle level, a profile, and a curvature reproducibility. A curvature reproducibility is important characteristics for forming a desired pattern shape, and it is particularly important that, in case of drawing a flexed line pattern, the pattern shape in a flexed portion can be reproduced, from the standpoint of a post process (ultrafine substrate working).

### Summary of the Invention

An obj ect of the present invention is to provide a positive resist composition improved in a resolution, a sensitivity, an initial particle level, a profile, and a curvature reproducibility, and a pattern forming method using the same.

The aforementioned object can be attained in the present invention by following structures:
(1) A positive resist composition comprising:
   (A) a resin which increases a solubility of the resin (A) in an alkali developer by an action of an acid;
   (B-1) a triarylsulfonium salt having a fluorine atom in a cation part of the triarylsulfonium salt, wherein the triarylsulfonium salt generates one of: an aliphatic sulfonic acid having a fluorine atom; and an aromatic sulfonic acid having a fluorine atom upon irradiation with one of an actinic ray and a radiation;
   (C) a nitrogen-containing basic compound; and
   (D) an organic solvent.
(2) The positive resist composition described in (1) above,
   wherein the organic solvent (D) comprises:
   at least one selected from the group A consisting of propylene glycol monoalkyl ether carboxylate; and
   at least one of: at least one selected from the group B consisting of propylene glycol monoalkyl ether, alkyl lactate and alkyl alkoxypropionate; and at least one selected from the group C consisting of γ-butyrolactone, ethylene carbonate, propylene carbonate and cyclohexanone.
(3) The positive resist composition described in (1) or (2) above, further comprising (B-2) a sulfonium salt not having a fluorine atom in a cation part of the sulfonium salt, wherein the sulfonium salt generates one of: an aliphatic sulfonic acid having a fluorine atom; and an aromatic sulfonic acid having a fluorine atom upon irradiation with one of an actinic ray and a radiation.
(4) The positive resist composition described in any one of (1) to (3) above,
   wherein the resin (A) comprises at least one alicyclic hydrocarbon structure having at least one of a monocyclic group and a polycyclic group.
(5) A pattern forming method comprising:
   forming a resist film with a positive resist composition according to (1) to (4) above;
   exposing the resist film, so as to form an exposed resist film; and
   developing the exposed resist film.
(6) The positive resist composition described in any one of (1) to (4) above,
   wherein the triarylsulfonium salt (B-1) is represented by a general formula (BI): 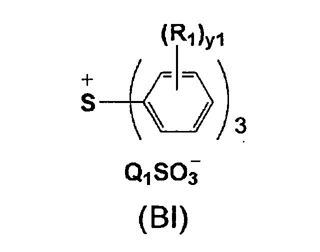 in which R₁ represents an alkyl group, an alicyclic hydrocarbon group, a hydroxyl group, a carboxyl group, an alkoxy group, a halogen atom or a phenylthio group, and, in case R₁ is present in plural units, R₁' s are mutually same or different; and at least one of R₁'s represents a fluorine atom, a fluorine-containing alkyl group, a fluorine-containing alicyclic hydrocarbon group, a fluorine-containing alkoxy group or a fluorine-containing phenylthio group;
   y1's each independently represents 0 to 5; and
   Q₁ represents a fluorine-containing alkyl group, a fluorine-containing cycloalkyl group, a fluorine-containing aryl group or a fluorinated alkyl group-containing aryl group.
(7) The positive resist composition described in (3) to (4) and (6) above,
   wherein the sulfonium salt (B-2) is represented by one of a general formula (BII) and (BIII): 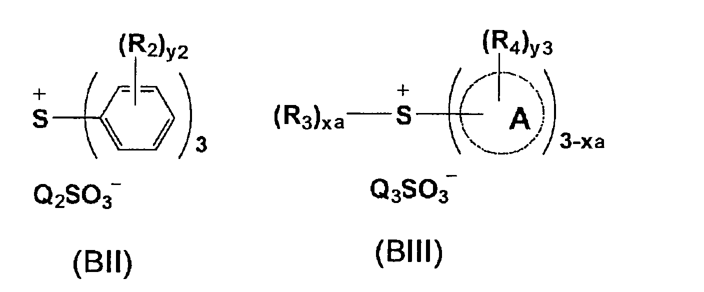
   In which R₂ represents an alkyl group, an alicyclic hydrocarbon group, a hydroxyl group, a carboxyl group or an alkoxy group, and in case R₂ is present in plural units, R₂'s are mutually same or different;
   Q₂ represents a fluorine-containing alkyl group, a fluorine-containing cycloalkyl group, a fluorine-containing aryl group or a fluorinated alkyl group-containing aryl group;
   y2's each independently represents 0 to 5;
   R₃ represents an alkyl group or an alicyclic hydrocarbon group, also in case R₃ is present in plural units, R₃' s are mutually same or different, and in case R₃ is present in plural units, R₃'s may be mutually bonded to form a ring;
   R₄ represents an alkyl group, an alicyclic hydrocarbon group, a hydroxyl group, a carboxyl group or an alkoxy group, and in case R₄ is present in plural units, R₄'s are mutually same or different;
   A represents an aromatic group or a heterocyclic group;
   Q₃ represents a fluorine-containing alkyl group, a fluorine-containing cycloalkyl group, a fluorine-containing aryl group or a fluorinated alkyl group-containing aryl group;
   Xa represents 1 to 3; and
   y3's each independently represents 0 to 5.
(8) The positive resist composition described in (4) and (6) to (7) above,
   wherein the resin (A) further comprises a unit having a group where an alkali-soluble group is protected with one of a 2-alkyl-2-adamantyl group and a 1-adamantyl-1-alkylalkyl group.
(9) The positive resist composition described in (4) and (6) to (8) above,
   wherein at least one of said at least one alicyclic hydrocarbon structure comprised in the resin (A) is a dihydroxyadamantane.
(10) The positive resist composition described in (1) to (4) and (6) to (9) above,
   wherein the resin (A) comprises four units (A-1) to (A-4) :
   (A-1) at least one selected from a unit represented by a general formula (I): 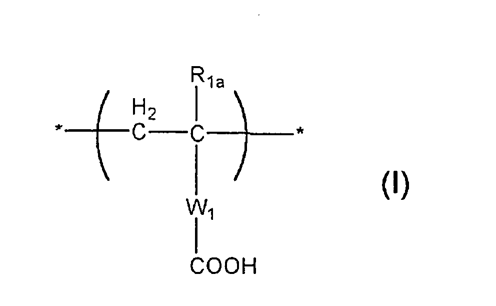 in which R₁ₐ represents a hydrogen atom or a methyl group; and
      W₁ represents a single bond or a divalent connecting group;
   (A-2) at least one selected from a unit having one of a group represented by general formulas (II-1) to (II-4): 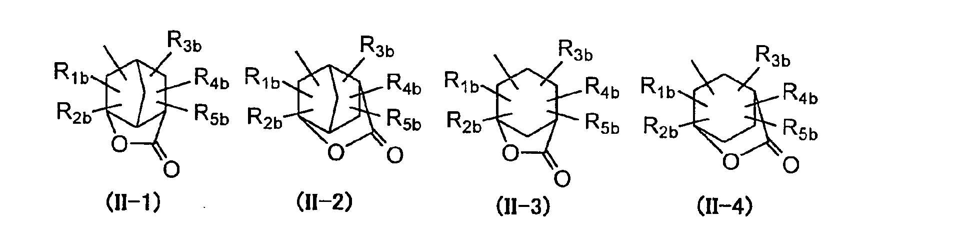 in which R_{1b} to R_{5b} each independently represents a hydrogen atom, an alkyl group, a cycloalkyl group or an alkenyl group, and two among R_{1b} to R_{5b} may be mutually bonded to form a ring;
   (A-3) at least one selected from a unit represented by a general formula (III): 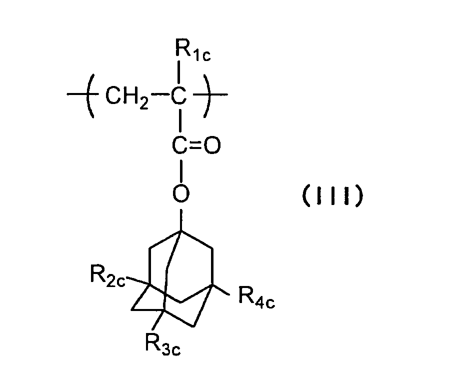 in which R_{1c} represents a hydrogen atom or a methyl group; and
      R_{2c} to R_{4c} each independently represents a hydrogen atom or a hydroxyl group, and at least one of R_{2c} to R_{4c} represents a hydroxyl group; and
   (A-4) at least one selected from a unit having a group where an alkali-soluble group is protected with one of a 2-alkyl-2-adamantyl group and a 1-adamantyl-1-alkylalkyl group.

### Detailed Description of the Invention

In the following, the present invention will be clarified in detail.

In the description of a group (atomic group) in the present specification, a description for which substitution or non-substitution is not specified includes a group having a substituent and a group not having a substituent. For example an "alkyl group" includes not only an alkyl group not having a substituent (non-substituted alkyl group) but also an alkyl group having a substituent (substituted alkyl group).

### [1] (A) Resin showing an increase of a solubility in an alkali developer by an action of an acid

The positive resist composition of the invention includes a resin which increases a solubility in an alkali developer by an action of an acid.

In case the positive resist composition of the invention is irradiated with a light of an ArF excimer laser, the resin which increases a solubility in an alkali developer by an action of an acid is preferably a resin which has a monocyclic or polycyclic alicyclic hydrocarbon structure and which increases a solubility in an alkali developer by an action of an acid (hereinafter also called "acid-decomposable alicyclic hydrocarbon resin").

The acid-decomposable alicyclic hydrocarbon resin is preferably a resin having a repeating unit including a partial structure containing an alicyclic hydrocarbon represented by following general formulas (pI) to (pVI) and increasing a solubility in an alkali developer by an action of an acid.

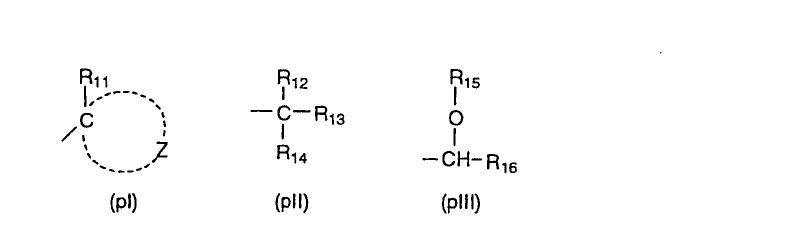

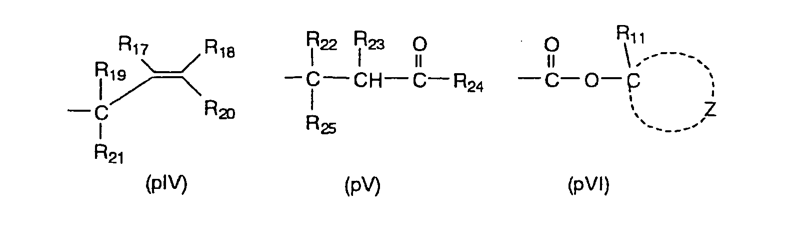

In the formulas, R₁₁ represents a methyl group, an ethyl group, an n-propyl group, an isopropyl group, an n-butyl group, an isobutyl group or a sec-butyl group; and Z represents an atomic group required for forming an alicyclic hydrocarbon group together with a carbon atom.

R₁₂ to R₁₆ each independently represents a linear or branched alkyl group, with 1 to 4 carbon atoms, or an alicyclic hydrocarbon group, in which at least one of R₁₂ to R₁₄, or R₁₅ or R₁₆ represents an alicyclic hydrocarbon group.

R₁₇ to R₂₁ each independently represents a hydrogen atom, a linear or branched alkyl group, with 1 to 4 carbon atoms or an alicyclic hydrocarbon group, in which at least one of R₁₇ to R₂₁ represents an alicyclic hydrocarbon group; and either of R₁₉ and R₂₁ represents a linear or branched alkyl group, with 1 to 4 carbon atoms or an alicyclic hydrocarbon group.

R₂₂ to R₂₅ each independently represents a hydrogen atom, a linear or branched alkyl group, with 1 to 4 carbon atoms or an alicyclic hydrocarbon group, in which at least one of R₂₂ to R₂₅ represents an alicyclic hydrocarbon group, and R₂₃ and R₂₄ may be mutually bonded to form a ring.

In the general formulas (pI) to (pVI), an alkyl group in R₁₂ to R₂₅ is preferably a linear or branched alkyl group with 1 to 4 carbon atoms. Such alkyl group can be, for example, a methyl group, an ethyl group, an n-propyl group, an isopropyl group, an n-butyl group, an isobutyl group, a sec-butyl group or a t-butyl group.

Also such alkyl group may further have a substituent which can for example be an alkoxy group with 1 to 4 carbon atoms, a halogen atom (fluorine atom, chlorine atom, bromine atom or iodine atom), an acyl group, an acyloxy group, a cyano group, a hydroxyl group, a carboxy group, an alkoxycarbonyl group, or a nitro group.

In R₁₁ to R₂₅, the alicyclic hydrocarbon group or the alicyclic hydrocarbon group formed by Z and a carbon atom may be monocyclic or polycyclic. Specific examples include a group having a monocyclo, bicyclo, tricyclo, tetracyclo structure or the like with 5 or more carbon atoms. Such group preferably has 6 to 30 carbon atoms, particularly preferably 7 to 25 carbon atoms. Such alicyclic hydrocarbon group may further have a substituent.

In the following, there are shown examples of the structure of an alicyclic portion in the alicyclic hydrocarbon group.

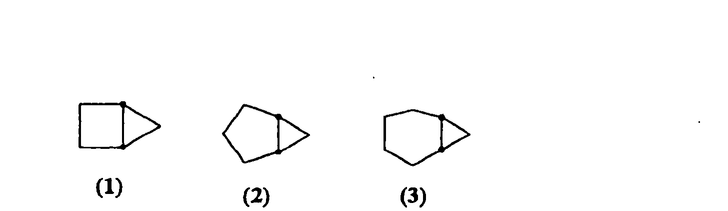

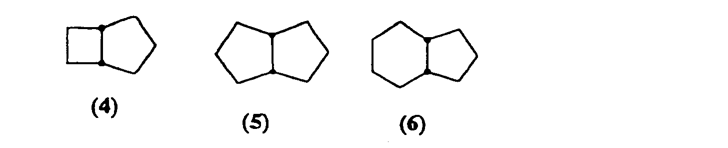

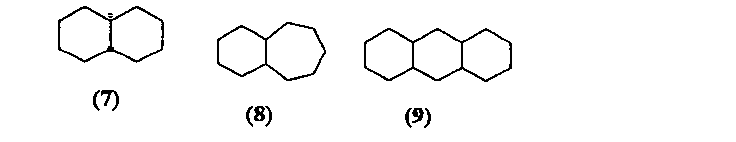

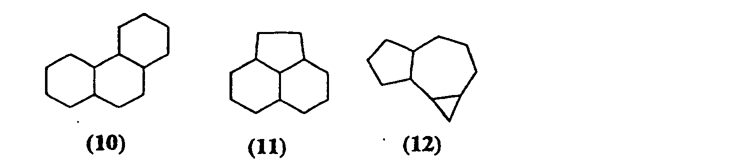

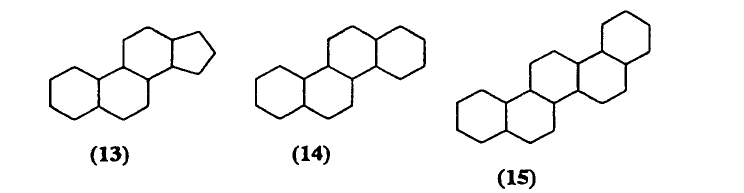

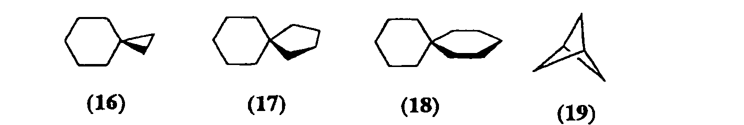

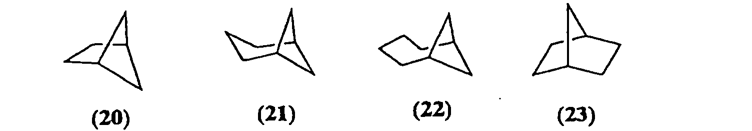

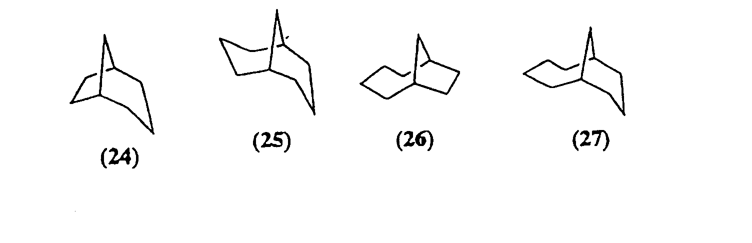

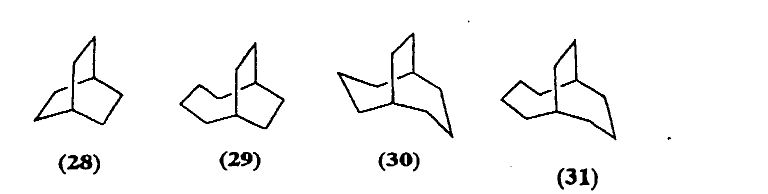

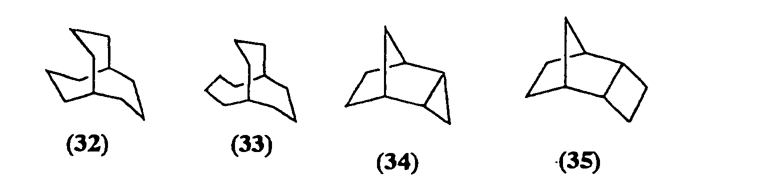

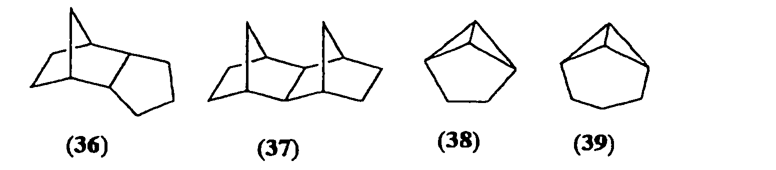

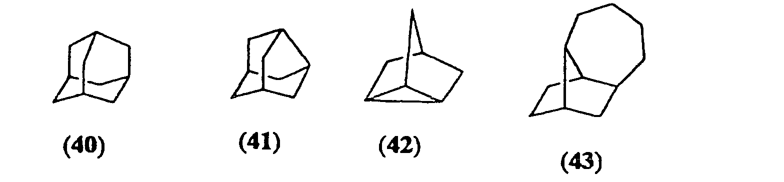

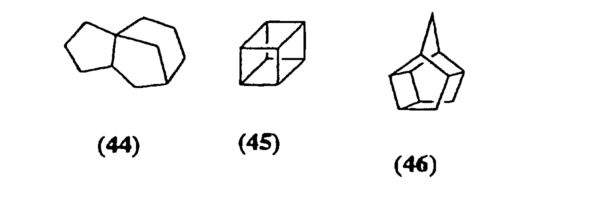

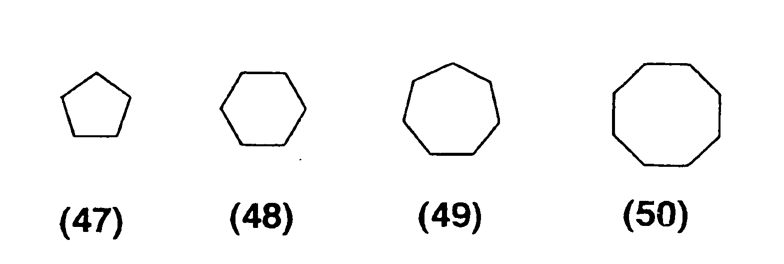

In the invention, the aforementioned alicyclic portion is preferably an adamantyl group, a noradamantyl group, a decaline residue, a tricyclodecanyl group, a tetracyclododecanyl group, a norbornyl group, a cedrol group, a cyclohexyl group, a cycloheptyl group, a cyclooctyl group, a cyclodecanyl group, or a cyclododecanyl group. More preferably it is an adamantyl group, a decaline residue, a norbornyl group, a cedrol group, a cyclohexyl group, a cycloheptyl group, a cyclooctyl group, a cyclodecanyl group, or a cyclododecanyl group.

Such alicyclic hydrocarbon group may have a substituent such as an alkyl group, a halogen atom, a hydroxyl group, an alkoxy group, a carboxyl group, or an alkoxycarbonyl group. The alkyl group is preferably a lower alkyl group such as a methyl group, an ethyl group, a propyl group, an isopropyl group or a butyl group, more preferably a methyl group, an ethyl group, a propyl group or an isopropyl group. The alkoxy group can be a group with 1 to 4 carbon atoms such as a methoxy group, an ethoxy group, a propoxy group or a butoxy group. The alkyl group or the alkoxy group may further have a substituent. Such substituent for the alkyl group or the alkoxy group can be a hydroxyl group, a halogen atom or an alkoxy group.

In the aforementioned resin, the structure represented by the general formulas (pI) to (pVI) can be used for protecting an alkali-soluble group. The alkali-soluble group can be various groups already known in this technical field.

Specific examples of such group include a carboxylic acid group, a sulfonic acid group, a phenol group and a thiol group, preferably a carboxylic acid group or a sulfonic acid group.

An alkali-soluble group protected by the structure represented by the general formulas (pI) to (pVI) in the aforementioned resin is preferably a group represented by following general formulas (pVII) to (pXI).

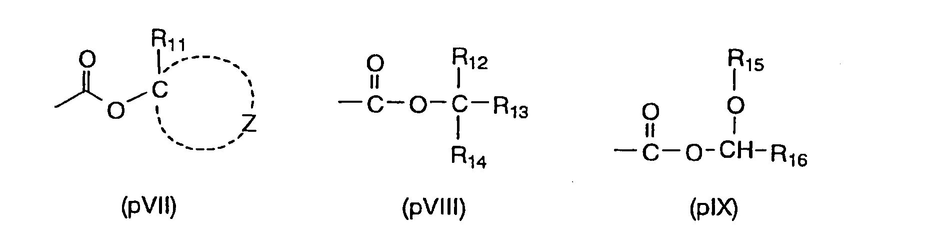

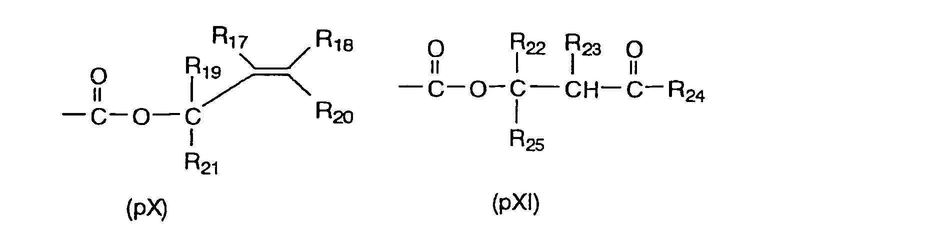

In these formulas, R₁₁ to R₂₅ and Z have the same definitions as described above.

In the aforementioned resin, a repeating unit including an alkali-soluble group protected by the structure represented by the general formulas (pI) to (pVI) is preferably a repeating unit represented by a following general formula (pA).

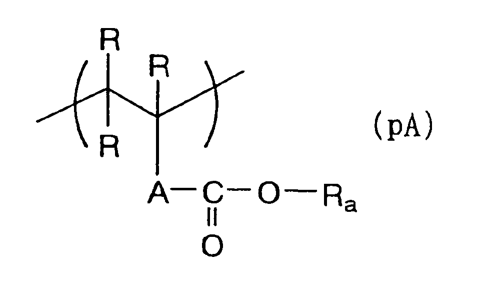

In the formula, R represents a hydrogen atom, a halogen atom or a linear or branched alkyl group with 1 to 4 carbon atoms. Plural Rs may be mutually same or different. An alkyl group as R may have a substituent such as an alkoxy group (preferably 3 or less carbon atoms).

A represents any one or a combination of two or more, selected from a group of a single bond, an alkylene group, an ether group, a thioether group, a carbonyl group, an ester group, an amide group, a sulfonamide group, an urethane group, and an urea group. An alkylene group as A may further have a substituent with 5 or less carbon atoms, such as an alkyl group or an alkoxy group.

Ra represents any one of the foregoing formulas (pI) to (pVI).

Ra preferably represents a 2-alkyl-2-adamantyl group or a1-adamantyl-1-alkylalkyl group. An alkyl group in such groups preferably has 1 to 8 carbon atoms, more preferably 1 to 3 carbon atoms.

In the following, there are shown specific examples of a monomer corresponding to the repeating unit represented by the general formula (pA).

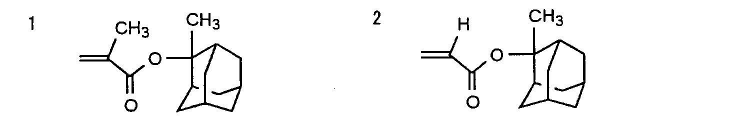

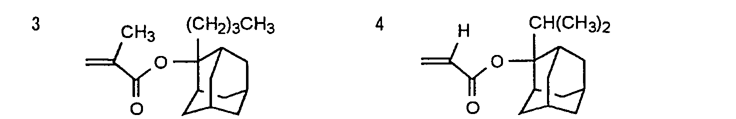

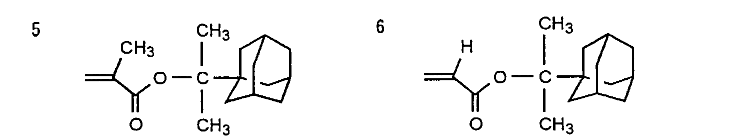

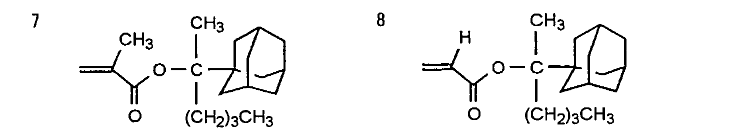

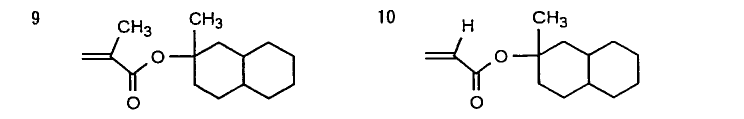

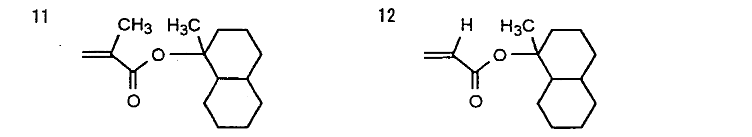

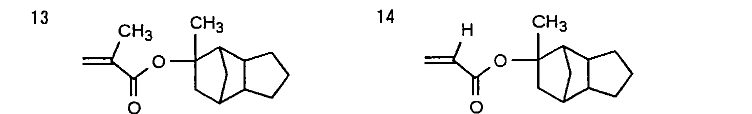

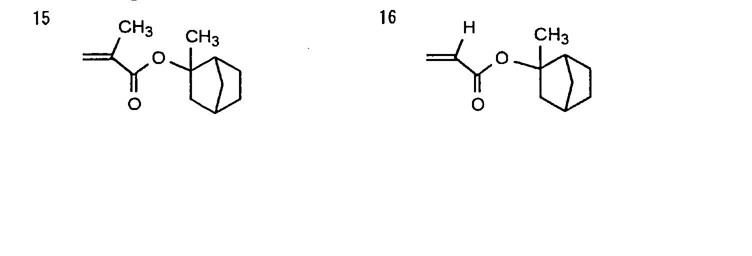

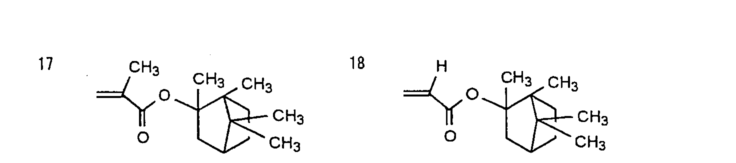

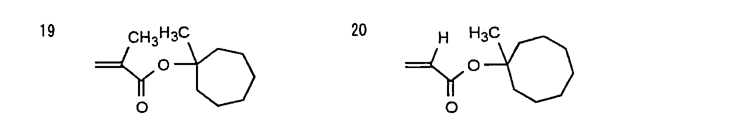

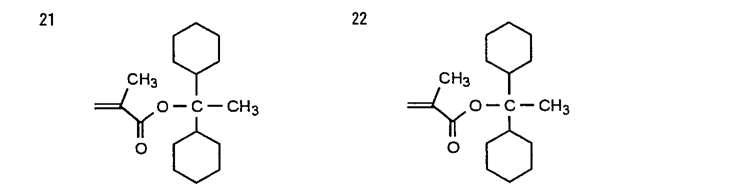

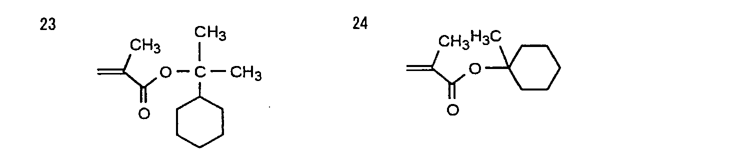

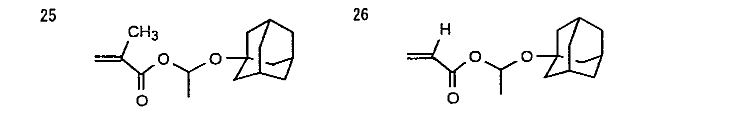

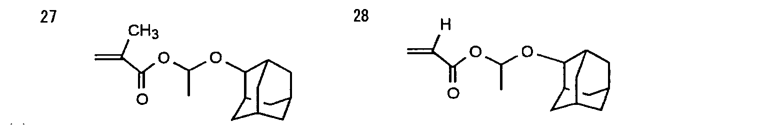

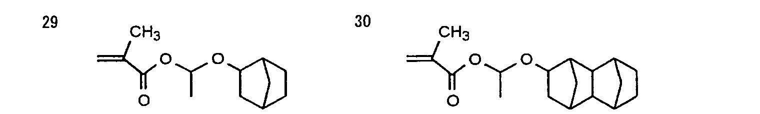

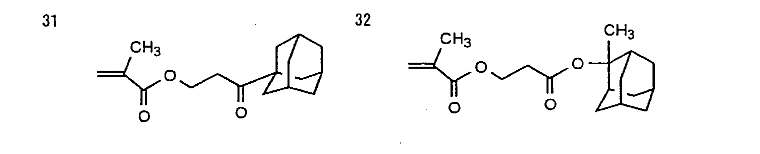

The acid-decomposable alicyclic hydrocarbon resin preferably has a repeating unit having an alkali-soluble group, protected by a 2-alkyl-2-adamantyl group, such as a repeating unit formed by the monomers 1 to 4 and 32.

The acid-decomposable alicyclic hydrocarbon resin preferably has a repeating unit having an alkali-soluble group, protected by a 1-adamantyl-1-alkylalkyl group, such as a repeating unit formed by the monomers 5 to 8.

The resin of the invention includes a group which is insoluble or little soluble in an alkali and is decomposed by an acid to become alkali-soluble (hereinafter also called "acid-decomposable group").

The acid-decomposable group may be included in a repeating unit having a partial structure including an alicyclic hydrocarbon represented by the aforementioned general formulas (pI) to (pVI), or in at least one of repeating units of a copolymerization component to be explained later.

The acid-decomposable group has a structure represented by -C (=O) -X₁-R₀.

In the formula, R₀ can be a tertiary alkyl group such as a t-butyl group or a t-amyl group, an isobornyl group, a 1-alkoxyethyl group such as a 1-ethoxyethyl group, a 1-butoxyethyl group, a 1-isobutoxyethyl group or a 1-cyclohexyloxyethyl group, an alkoxymethyl group such as a 1-methoxymethyl group or a 1-ethoxymethyl group, a 3-oxoalkyl group, a tetrahydropyranyl group, a tetrahydrofuranyl group, a trialkylsilyl ester group, a 3-oxycyclohexyl ester group, a 2-methyl-2-adamantyl group, or a mevalonic lactone residue; and X₁ represents an oxygen atom, a sulfur atom, -NH-, -NHSO₂- or -NHSO₂NH-.

The acid-decomposable alicyclic hydrocarbon resin preferably includes further a repeating unit having a group represented by a following general formula (IIIA).

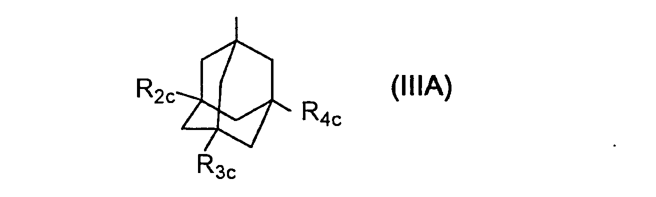

In the general formula (IIIA), R_{2c} to R_{4c} each independently represents a hydrogen atom or a hydroxyl group, and at least one of R_{2c} to R_{4c} represents a hydroxyl group.

The group represented by the general formula (IIIA) is preferably a dihydroxy member or a monohydroxy member, preferably a dihydroxy member.

The repeating unit having the group represented by the general formula (IIIA) can be a repeating unit represented by a following general formula (III).

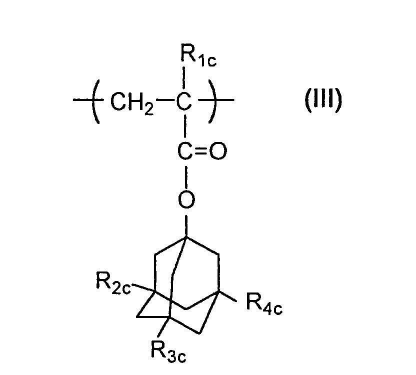

In the general formula (III), R_{1c} represents a hydrogen atom or a methyl group.

R_{2c} to R_{4c} each independently represents a hydrogen atom or a hydroxyl group, and at least one of R_{2c} to R_{4c} represents a hydroxyl group.

In the following there are shown specific examples of the repeating unit including the structure represented by the general formula (IIIA), but such examples are not restrictive.

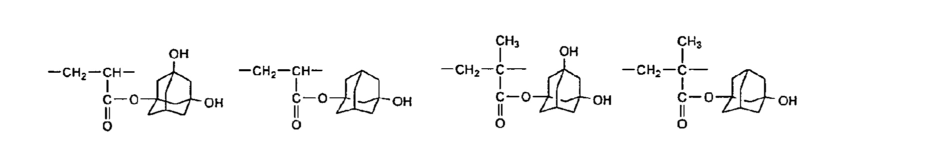

The acid-decomposable alicyclic hydrocarbon resin may further include a repeating unit having a lactone structure represented by a following general formula (IV).

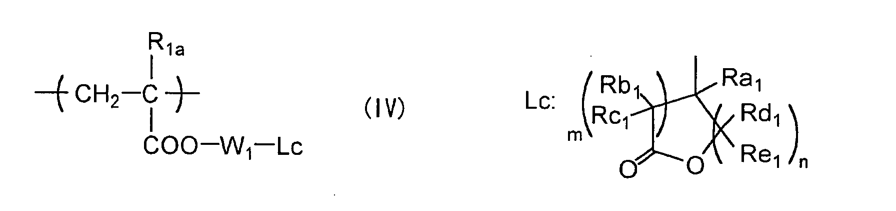

In the general formula (IV), R₁ₐ represents a hydrogen atom or a methyl group.

W₁ represents any one or a combination of two or more, selected from a group of a single bond, an alkylene group, an ether group, a thioether group, a carbonyl group, and an ester group.

Rₐ₁, R_{b1}, R_{c1}, R_{d1} and Rₑ₁ each independently represents a hydrogen atom or an alkyl group with 1 to 4 carbon atoms; m and n each independently represents an integer of 0 to 3, in which m+n is from 2 to 6.

The alkyl group with 1 to 4 carbon atoms, represented by Rₐ₁ to Rₑ₁ can be, for example, a methyl group, an ethyl group, a propyl group, an isopropyl group, an n-butyl group, an isobutyl group, a sec-butyl group or a t-butyl group.

In the general formula (IV), the alkylene group represented by W₁ can be a group represented by a following formula:

- [C(Rf) (Rg)] ᵣ₁-

in which Rf and Rg each represents a hydrogen atom, an alkyl group, a halogen atom, a hydroxyl group, or an alkoxy group, and both may be mutually same or different. The alkyl group is preferably a lower alkyl group such as a methyl group, an ethyl group, a propyl group, an isopropyl group or a butyl group, more preferably a methyl group, an ethyl group, a propyl group or an isopropyl group. The alkoxy group can be one with 1 to 4 carbon atoms such as a methoxy group, an ethoxy group, a propoxy group or a butoxy group. The alkyl group or the alkoxy group may further have a substituent. Such further substituent on the alkyl or alkoxy group can be a hydroxyl group, a halogen atom, or an alkoxy group. The halogen atom can be a chlorine atom, a bromine atom, a fluorine atom or an iodine atom. r₁ represents an integer from 1 to 10.

In the following, there are shown specific examples of the repeating unit represented by the general formula (IV), but such examples are not restrictive.

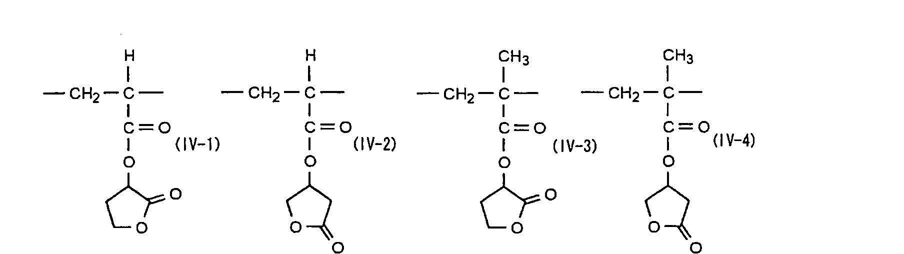

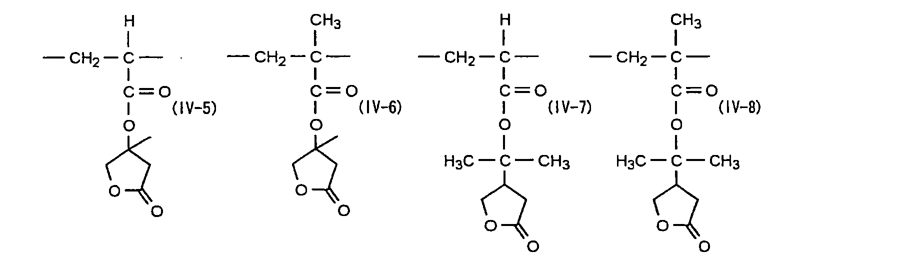

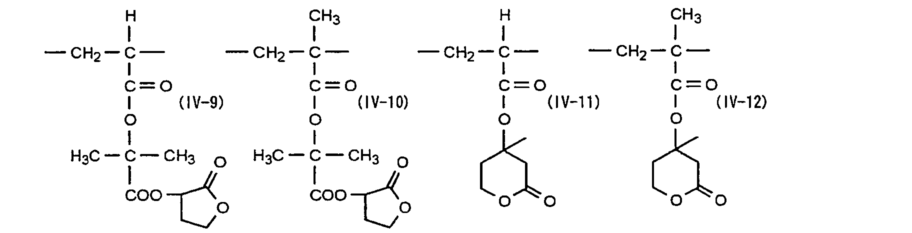

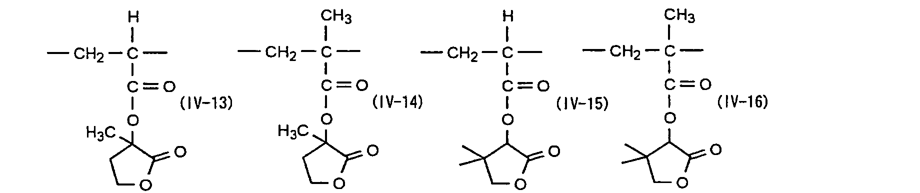

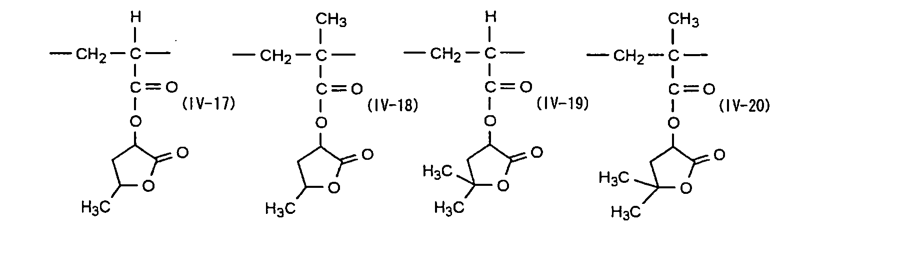

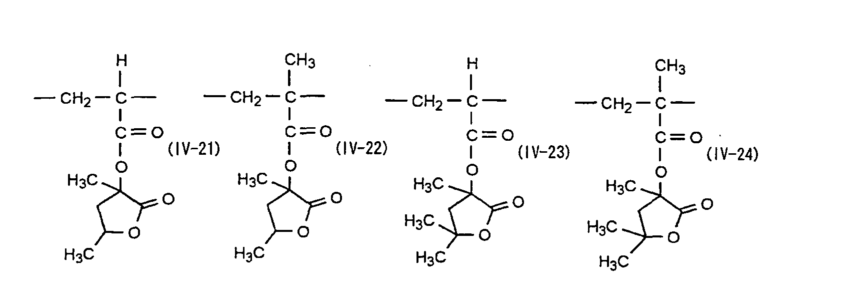

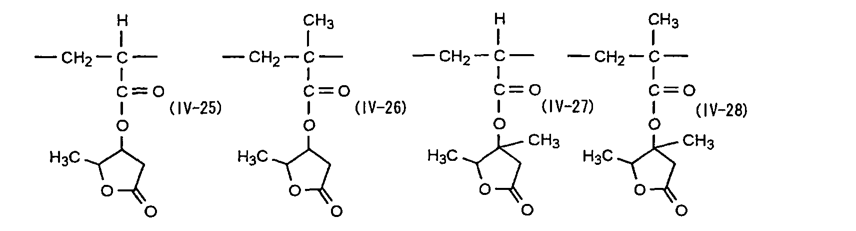

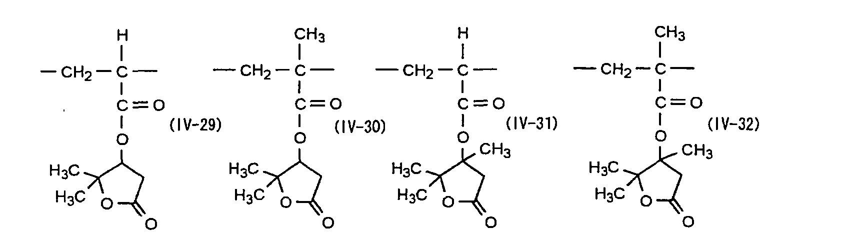

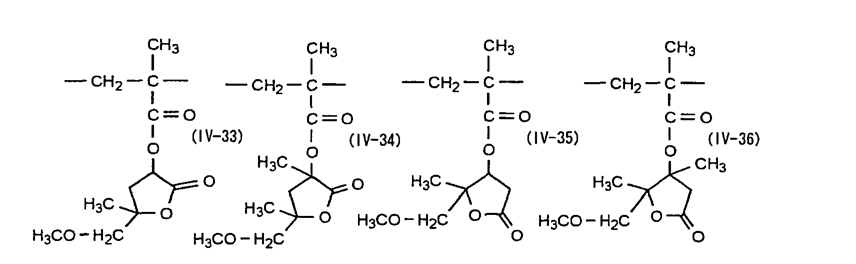

Among the specific examples of the general formulas (IV) , (IV-17) to (IV-36) are preferable in improving an exposure margin.

Also in the structure represented by the general formula (IV), an acrylate structure is preferred in improving an edge roughness.

The acid-decomposable alicyclic hydrocarbon resin may further include a repeating unit having a group represented by any one of following general formulas (II-1) to (II-4).

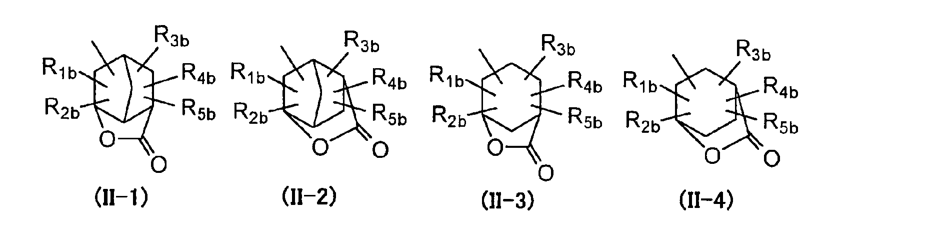

In the general formulas (II-1) to (II-4), R_{1b} to R_{5b} each independently represents a hydrogen atom, an alkyl group, a cycloalkyl group or an alkenyl group, and two within R_{1b} to R_{5b} may be mutually bonded to form a ring.

In the general formulas (II-1) to (II-4), an alkyl group represented by R_{1b} to R_{5b} can be a linear or branched alkyl group which may have a substituent.

The linear or branched alkyl group is preferably a linear or branched alkyl group with 1 to 12 carbon atoms, more preferably a linear or branched alkyl group with 1 to 10 carbon atoms and further preferably a methyl group, an ethyl group, a propyl group, an isopropyl group, an n-butyl group, an isobutyl group, a sec-butyl group, a t-butyl group, a pentyl group, a hexyl group, a heptyl group, an octyl group, a nonyl group or a decyl group.

A cycloalkyl group represented by R_{1b} to R_{5b} preferably has 3 to 8 carbon atoms, such as a cyclopropyl group, a cyclopentyl group, a cyclohexyl group, a cycloheptyl group or a cyclooctyl group.

An alkenyl group represented by R_{1b} to R_{5b} preferably has 2 to 6 carbon atoms, such as a vinyl group, a propenyl group, a butenyl group, or a hexenyl group.

Also a ring formed by a bonding of two of R_{1b} to R_{5b} can be a 3 to 8 membered ring such as a cyclopropane ring, a cyclobutane ring, a cyclopentane ring, a cyclohexane ring or a cyclooctane ring.

In the general formulas (II-1) to (II-4), R_{1b} to R_{5b} each may be bonded to any of the carbon atoms constituting the cyclic structure.

Also a preferable substituent which the alkyl group, the cycloalkyl group or the alkenyl group mentioned above may have can be, for example, an alkoxy group with 1 to 4 carbon atoms, a halogen atom (fluorine atom, chlorine atom, bromine atom or iodine atom) , an acyl group with 2 to 5 carbon atoms, an acyloxy group with 2 to 5 carbon atoms, a cyano group, a hydroxyl group, a carboxy group, an alkoxycarbonyl group with 2 to 5 carbon atoms, or a nitro group.

A repeating unit having a group represented by the general formulas ( II-1) to (II-4) can be one represented by a following general formula (II).

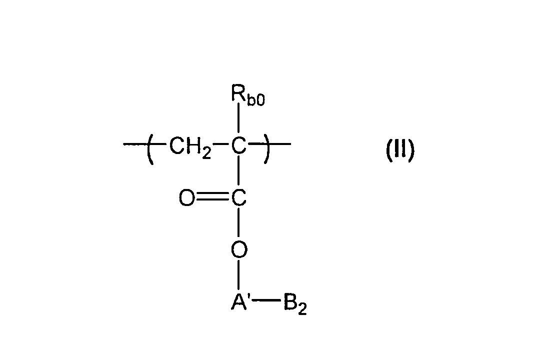

In the general formula (II), R_{b0} represents a hydrogen atom, a halogen atom or an alkyl group with 1 to 4 carbon atoms. Examples of a preferred substituent which the alkyl group as R_{b0} may have are the same as the aforementioned examples of the preferred substituent which the alkyl group as R_{1b} may have in the general formulas (II-1) to (II-4).

A halogen atom as R_{b0} can be a fluorine atom, a chlorine atom, a bromine atom or an iodine atom. R_{b0} is preferably a hydrogen atom.

A' represents a single bond, an ether group, an ester group, a carbonyl group, an alkylene group or a divalent group formed by combining these.

B₂ represents a group indicated by any one of the general formulas (II-1) to (II-4). The aforementioned combined divalent group as A' can be, for example, one of following formulas.

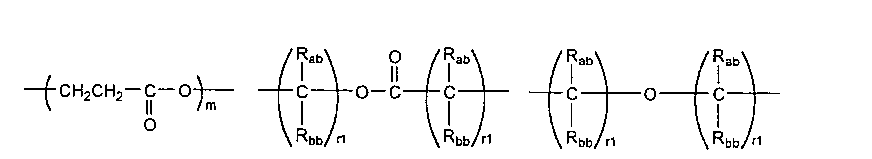

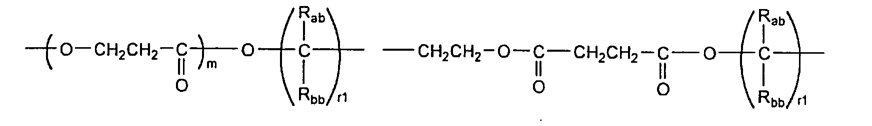

In these formulas, R_{ab} and R_{bb} each represents a hydrogen atom, an alkyl group, a halogen atom, a hydroxyl group, or an alkoxy group, and both may be mutually same or different.

An alkyl group is preferably a lower alkyl group such as a methyl group, an ethyl group, a propyl group, an isopropyl group or a butyl group, more preferably a methyl group, an ethyl group, a propyl group, or an isopropyl group. An alkoxy group can be a group with 1 to 4 carbon atoms, such as a methoxy group, an ethoxy group, a propoxy group or a butoxy group. The alkyl or alkoxy group may further have a substituent. Such further substituent of the alkyl or alkoxy group can be a hydroxyl group, a halogen atom or an alkoxy group. The halogen atom can be a chlorine atom, a bromine atom, a fluorine atom or an iodine atom. r1 represents an integer of 1 to 10, preferably 1 to 4. m represents an integer of 1 to 3, preferably represents 1 or 2.

In the following there will be shown specific examples of the repeating unit represented by the general formula (II), but the content of the invention is not limited to such examples.

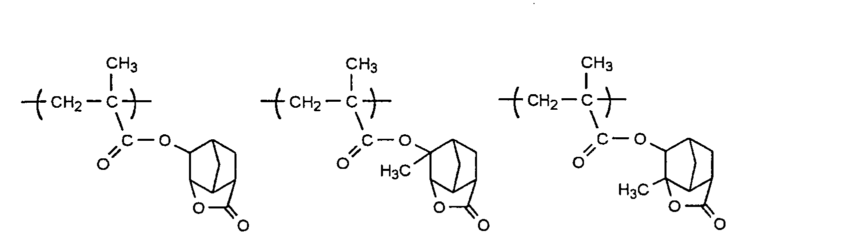

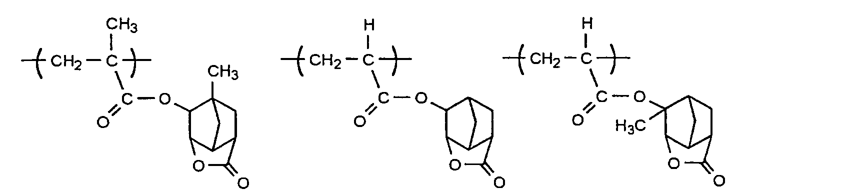

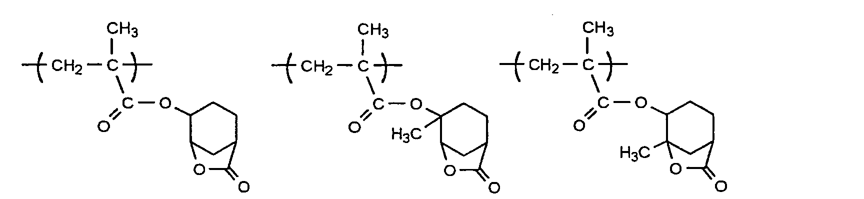

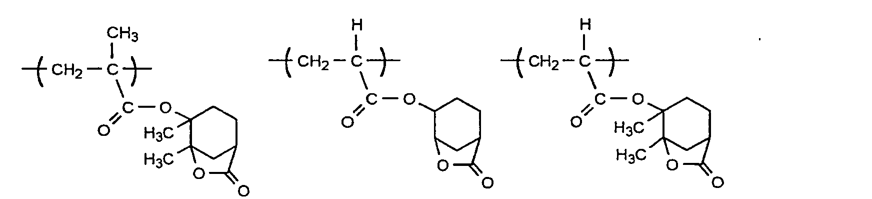

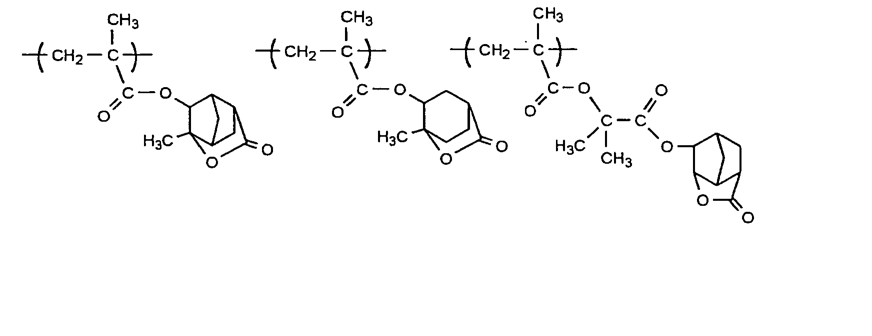

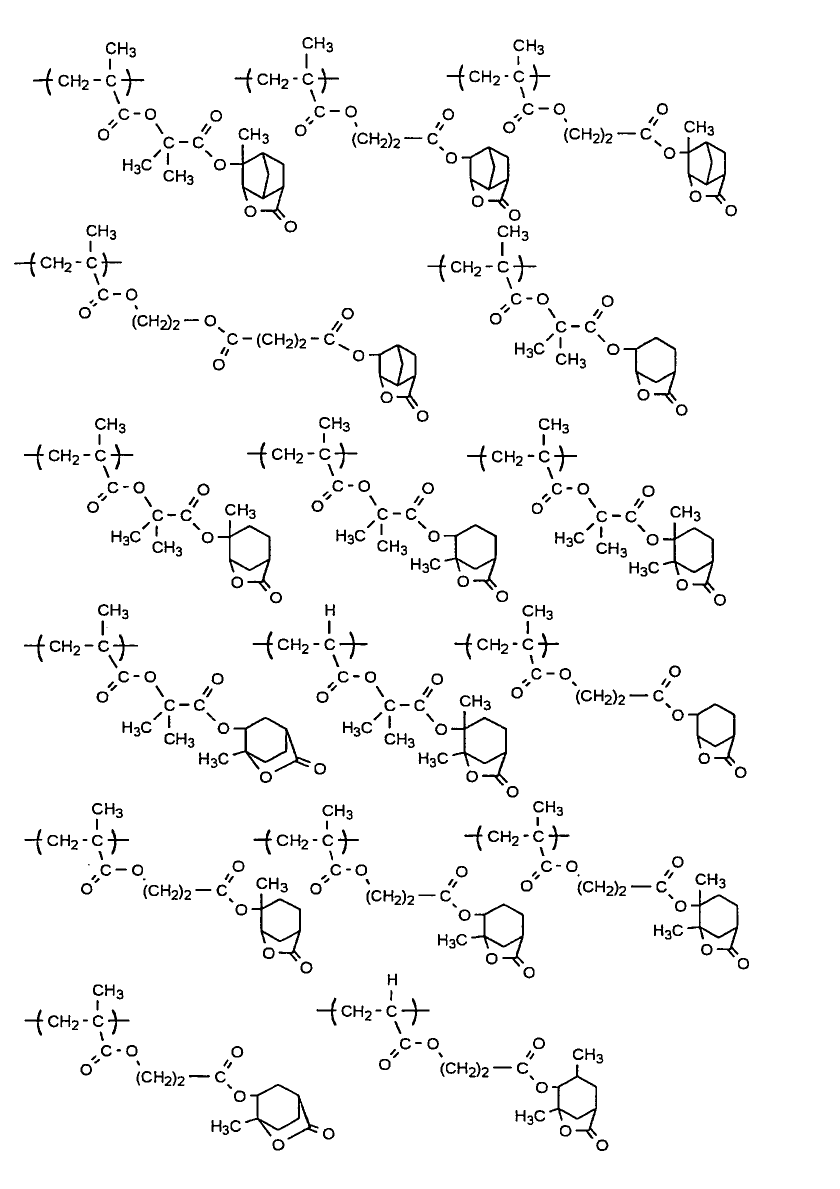

The acid-decomposable alicyclic hydrocarbon resin may further include a repeating unit represented by a following general formula (V).

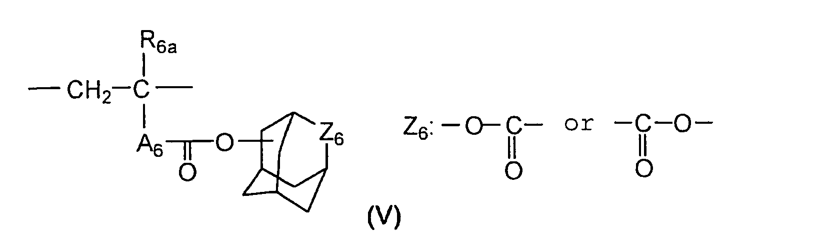

In the general formula (V), A₆ represents a single group or a combination of two or more groups selected from a single bond, an alkylene group, a cycloalkylene group, an ether group, a thioether group, a carbonyl group and an ester group.

R₆ₐ represents a hydrogen atom, an alkyl group with 1 to 4 carbon atoms, a cyano group or a halogen atom.

In the general formula (V), an alkylene group as A₆ can be a group represented by a following formula:

- [C (Rnf) (Rng) ] ᵣ-

wherein Rnf and Rng each represents a hydrogen atom, an alkyl group, a halogen atom, a hydroxyl group or an alkoxy group, and both may be mutually same or different. An alkyl group is preferably a lower alkyl group such as a methyl group, an ethyl group, a propyl group, an isopropyl group or a butyl group, more preferably a methyl group, an ethyl group, a propyl group or an isopropyl group. An alkoxy group can be a group with 1 to 4 carbon atoms such as a methoxy group, an ethoxy group, a propoxy group or a butoxy group. The alkyl group or the alkoxy group may further have a substituent. A further substituent on the alkyl or alkoxy group can be a hydroxyl group, a halogen atom or an alkoxy group. A halogen atom can be a chlorine atom, a bromine atom, a fluorine atom or an iodine atom. r represents an integer from 1 to 10.

In the general formula (V), a cyclohexylene group as A₆ can be a group with 3 to 10 carbon atoms, such as a cyclopentylene group, a cyclohexylene group or a cyclooctylene group.

A bridged alicyclic group including Z₆ may have a substituent. Such substituent can be, for example, a halogen atom, an alkoxy group (preferably with 1 to 4 carbon atoms), an alkoxycarbonyl group (preferably with 1 to 5 carbon atoms) , an acyl group (such as a formyl group or a benzoyl group), an acyloxy group (such as a propylcarbonyloxy group or a benzoyloxy group), an alkyl group (preferably with 1 to 4 carbon atoms) , a carbonyl group, a hydroxyl group, or an alkylsulfonylsulfamoyl group (such as -CONHSO₂CH₃). The alkyl group as the substituent may be further substituted with a hydroxyl group, a halogen atom, an alkoxy group (preferably 1 to 4 carbon atoms) or the like.

In the general formula (V), an oxygen atom of an ester group bonded to A₆ may be bonded to any of the carbon atoms constituting the bridged alicyclic structure including Z₆.

In the following, there are shown specific examples of the repeating unit represented by the general formula (V) , but such examples are not restrictive.

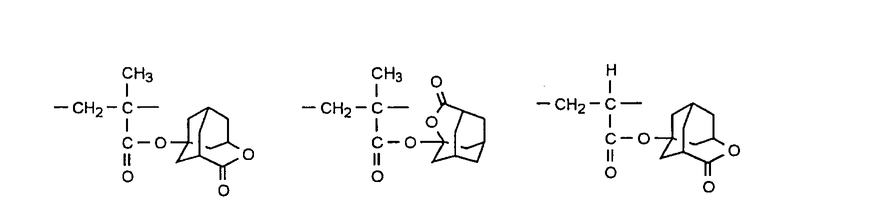

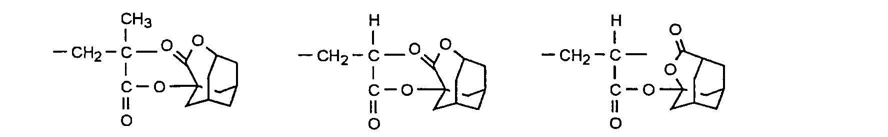

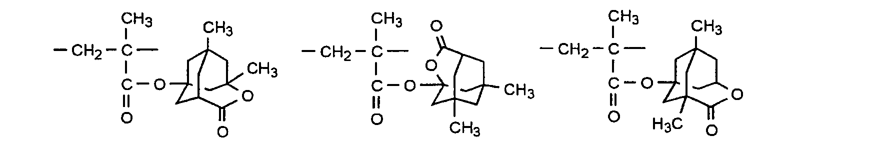

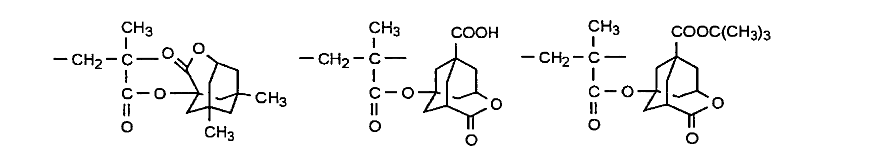

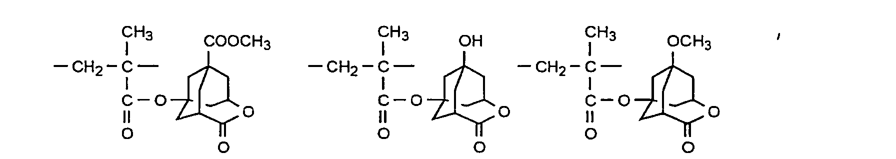

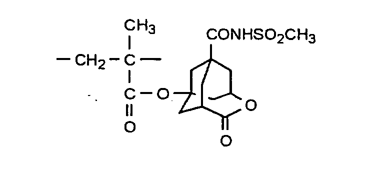

The acid-decomsable alicyclic hydrocarbon resin may include a repeating unit represented by a following general formula (I).

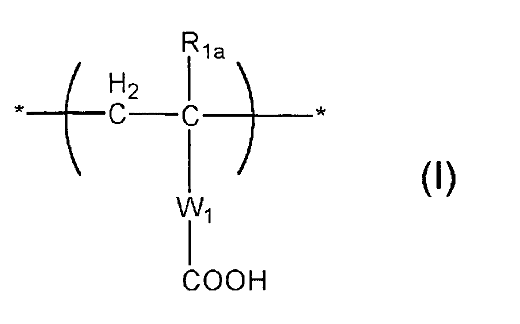

In the general formula (I), R₁ₐ represents a hydrogen atom or a methyl group. W₁ represents a single bond or a divalent connecting group.

A divalent connecting group as W₁ can be a single group or a combination of two or more groups selected from an alkylene group, an ether group, a thioether group, a carbonyl group and an ester group.

In the general formula (I), an alkylene group as W₁ can be a group represented by a following formula:

-[C(Rf) (Rg) ] ᵣ₁-

wherein Rf and Rg each represents a hydrogen atom, an alkyl group, a halogen atom, a hydroxyl group or an alkoxy group, and both may be mutually same or different. An alkyl group is preferably a lower alkyl group such as a methyl group, an ethyl group, a propyl group, an isopropyl group or a butyl group, more preferably a methyl group, an ethyl group, a propyl group or an isopropyl group. An alkoxy group can be a group with 1 to 4 carbon atoms such as a methoxy group, an ethoxy group, a propoxy group or a butoxy group. A further substituent on the alkyl or alkoxy group can be a hydroxyl group, a halogen atom or an alkoxy group. A halogen atom can be a chlorine atom, a bromine atom, a fluorine atom or an iodine atom. r1 represents an integer from 1 to 10.

In the following, there are shown specific examples of the repeating unit represented by the general formula (I), but these examples are not restrictive.

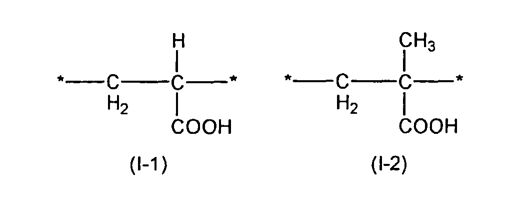

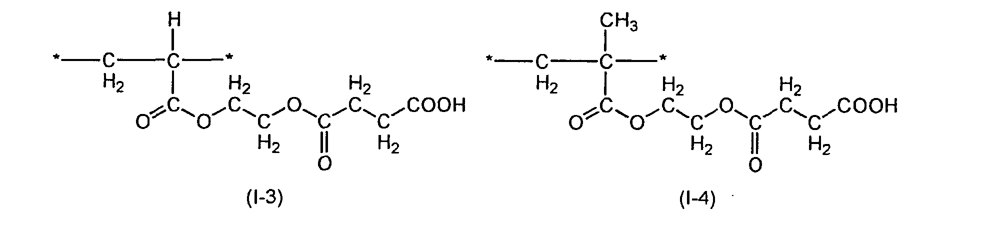

The acid-decomposable alicyclic hydrocarbon resin constituting the component (A) may include, in addition to the aforementioned repeating units, various repeating units for the purpose of regulating a dry etching resistance, a matching to a standard developer, an adhesion to a substrate, a resist profile and general properties required for the resist such as a resolution, a heat resistance and a sensitivity.

Such repeating unit can be those corresponding to following monomers, but such examples are not restrictive.

Thus a fine adjustment is rendered possible on the performances required for the acid-decomposable resin, particularly:
(1) solubility in a coating solvent;
(2) film forming property (glass transition point);
(3) alkali developability;
(4) film thickness loss (hydrophilicity/hydrophobilicty, selection of alkali-soluble group);
(5) adhesion of an unexposed part to the substrate; and
(6) dry etching resistance.

Such monomer can be a compound having an addition polymerizable unsaturated bond selected from an acrylate ester, a methacrylate ester, an acrylamide, a methacrylamide, an allyl compound, a vinyl ether and a vinyl ester.

Specific examples include following monomers:
An acrylate ester (preferably an alkyl acrylate with 1 to 10 carbon atoms in the alkyl group):
   methyl acrylate, ethyl acrylate, propyl acrylate, amyl acrylate, cyclohexyl acrylate, ethylhexyl acrylate, octyl acrylate, t-octyl acrylate, chloroethyl acrylate, 2-hydroxyethyl acrylate, 2,2-dimethylhydroxypropyl acrylate, 5-hydroxypentyl acrylate, trimethylolpropane monoacrylate, pentaerythritol monoacrylate, benzyl acrylate, methoxybenzyl acrylate, furfuryl acrylate, tetrahydrofurfuryl acrylate and the like.
A methacrylate ester (preferably an alkyl methacrylate with 1 to 10 carbon atoms in the alkyl group):
   methyl methacrylate, ethyl methacrylate, propyl methacrylate, isopropylmethacrylate, amylmethacrylate, hexyl methacrylate, cyclohexyl methacrylate, benzyl methacrylate, chlorobenzylmethacrylate, octylmethacrylate, 2-hydroxyethyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, furfuryl methacrylate, tetrahydrofurfuryl methacrylate and the like.
An acrylamide:
   acrylamide, N-alkylacrylamide (with 1 to 10 carbon atoms in the alkyl group, such as a methyl group, an ethyl group, a propyl group, a butyl group, a t-butyl group, a heptyl group, an octyl group, a cyclohexyl group, or a hydroxyethyl group) , N,N-dialkylacrylamide (with 1 to 10 carbon atoms in the alkyl group, such as a methyl group, an ethyl group, a butyl group, an isobutyl group, an ethylhexyl group, or a cyclohexyl group) , N-hydroxyethyl-N-methylacrylamide, N-2-acetamidethyl-N-acetylacrylamide and the like.
A methacrylamide:
   methacrylamide, N-alkylmethacrylamide (with 1 to 10 carbon atoms in the alkyl group, such as a methyl group, an ethyl group, a t-butyl group, an ethylhexyl group, a hydroxyethyl group or a cyclohexyl group), N,N-dialkylmethacrylamide (alkyl group being for example an ethyl group, a propyl group or a butyl group), N-hydroxyethyl-N-methyl methacrylamide and the like.
An allyl compound:
   an allyl ester (such as allyl acetate, allyl caproate, allyl caprylate, allyl laurate, allyl palmitate, allyl stearate, allyl benzoate, allyl acetacetate, or allyl lactate), allyloxyethanol and the like.
A vinyl ether:
   alkyl vinyl ether (such as hexyl vinyl ether, octyl vinyl ether, decyl vinyl ether, ethylhexyl vinyl ether, methoxyethyl vinyl ether, ethoxyethyl vinyl ether, chlorethyl vinyl ether, 1-methyl-2,2-dimethylpropoyl vinyl ether, 2-ethylbutyl vinyl ether, hydroxyethyl vinyl ether, diethylene glycol vinyl ether, diethylaminoethyl vinyl ether, diethylaminoethyl vinyl ether, butylaminoethyl vinyl ether, benzyl vinyl ether, tetrahydrofurfuryl vinyl ether and the like.
A vinyl ester:
   vinyl butyrate, vinyl isobutyrate, vinyl trimethylacetate, vinyl diethylacetate, vinyl valeate, vinyl caproate, vinyl chloracetate, vinyl dichloracetate, vinyl methoxyacetate, vinyl butoxyacetate, vinyl acetacetate, vinyl lactate, vinyl-β-phenylbutyrate, vinyl cyclohexylcarboxylate and the like.
A dialkyl itaconate:
   dimethylitaconate, diethylitaconate, dibutylitaconate and the like.
A dialkyl or monoalkyl ester of fumarate:
   dibutyl fumarate and the like.

Others:
crotonic acid, itaconic acid, maleic anhydride, maleimide, acrylonitrile, methacrylonitrile, maleylonitrile andthe like.

In addition to the foregoing, there may be copolymerized any unsaturated compound that has an addition polymerizing property capable of copolymerizing with the monomers corresponding to the aforementioned various repeating units.

In the acid-decomposable alicyclic hydrocarbon resin, the molar ratio of the repeating units is suitably selected in order to regulate, in the resist, a dry etching resistance, a matching to a standard developer, an adhesion to a substrate, a resist profile and general properties required for the resist such as a resolution, a heat resistance and a sensitivity.

The acid-decomposable alicyclic hydrocarbon resin preferably includes following four repeating units (A-1) to (A-4):
(A-1): at least a repeating unit selected from the repeating units represented by the general formula (I);
(A-2): at least a repeating unit selected from the repeating units represented by the general formulas (II-1) to (II-4);
(A-3): at least a repeating unit selected from the repeating units represented by the general formula (III); and
(A-4): at least a repeating unit selected from the repeating units having an alkali-soluble group protected by a 2-alkyl-2-adamantyl group or a 1-adamantyl-1-alkylakyl group.

In the acid-decomposable alicyclic hydrocarbon resin, the repeating unit having the partial structure including the alicyclic hydrocarbon represented by the general formulas (pI) to (pVI) preferably has a content of 30 to 70 % by mole in all the repeating units, more preferably 35 to 65 % by mole and further preferably 40 to 60 % by mole.

Also a content of the repeating unit derived from the monomer of the aforementioned additional copolymerization component, in the resin, can be suitably selected according to the desired performances of the resist, but it is in general preferably 99 % by mole or less with respect to a number of moles of the repeating unit having the partial structure including the alicyclic hydrocarbon represented by the general formulas (pI) to (pVI), more preferably 90 % by mole or less and further preferably 80 % by mole or less.

In case the composition of the invention is intended for an exposure with an ArF, the resin preferably does not include an aromatic group in consideration of the transparency to the light of the ArF.

In the acid-decomposable alicyclic hydrocarbon resin, the repeating unit having the acid-decomposable group preferably has a content of 15 to 50 % by mole in all the repeating units, more preferably 20 to 40 % by mole.

In the acid-decomposable alicyclic hydrocarbon resin including the repeating units (A-1) to (A-4), a content of the repeating unit (A-1) is preferably 20 to 70 % by mole with respect to all the repeating units, more preferably 25 to 60 % by mole.

A content of the repeating unit (A-2) is preferably 20 to 70 % by mole with respect to all the repeating units, more preferably 25 to 60 % by mole.

A content of the repeating unit (A-3) is preferably 5 to 50 % by mole with respect to all the repeating units, more preferably 10 to 40 % by mole, and further preferably 15 to 35 % by mole.

A content of the repeating unit (A-4) is preferably 30 to 70 % by mole with respect to all the repeating units, more preferably 35 to 65 % by mole, and further preferably 40 to 60 % by mole.

The acid-decomposable alicyclic hydrocarbon resin to be employed in the invention can be synthesized according to an ordinary method (for example radical polymerization). For example, it can be synthesized, as an ordinary synthesizing method, by charging monomer species in a reactor collectively or in the course of reaction, uniformly dissolving them in a reaction solvent for example an ether such as tetrahydrofuran, 1, 4-dioxane or diisopropyl ether, a ketone such as methyl ethyl ketone or methyl isobutyl ketone, an ester such as ethyl acetate, or a solvent used for dissolving the composition of the invention such as propylene glycol monomethyl ether acetate, heating the solution if necessary in an inert gas atmosphere such as nitrogen or argon, and initiating a polymerization with a commercially available radical polymerization initiator (such as an azo initiator or a peroxide). The initiator is added additionally or added in divided portions if necessary, and, after the termination of the reaction, the solution is charged into a solvent to recover a desired polymer by a method of powder or solid recovery.

A concentration at the reaction is usually 20 % by weight or more, preferably 30 % by weight or more and further preferably 40 % by weight or more. A reaction temperature is normally 10 to 150°C, preferably 30 to 120°C, and further preferably 50 to 100°C.

Each of the repeating structural units represented by the foregoing examples may be employed singly or in a mixture of plural kinds.

Also in the invention, the resin may be employed singly or in a combination of plural kinds.

The resin of the invention has a weight-averaged molecular weight, measured by a GPC method as a value converted into polystyrene, usually within a range of 1,000 to 200,000, preferably 3,000 to 20,000.

A degree of dispersion (Mw/Mn) is usually within a range of 1 to 10, preferably 1 to 5 and further preferably 1 to 4. A smaller the degree of dispersion improves a resolution, a resist profile, a better roughness with a smoother side wall of the resist pattern.

In the positive resist composition of the invention, all the resin of the invention has a proportion in the entire composition preferably of 40 to 99. 99 % by weight with respect to all the resist solid, and more preferably 50 to 99.97 % by weight.

### [2] (B-1) A triarylsulfonium salt containing a fluorine atom in a cation part and generating an aliphatic or aromatic sulfonic acid having a fluorine atom upon irradiation with an actinic ray or a radiation

The positive resist composition of the invention includes a triarylsulfonium salt containing a fluorine atom in a cation part and generating an aliphatic or aromatic sulfonic acid having a fluorine atom upon irradiation with an actinic ray or a radiation.

The triarylsulfonium salt containing a fluorine atom in a cation part and generating an aliphatic or aromatic sulfonic acid having a fluorine atom upon irradiation with an actinic ray or a radiation is preferably represented by a following general formula (BI).

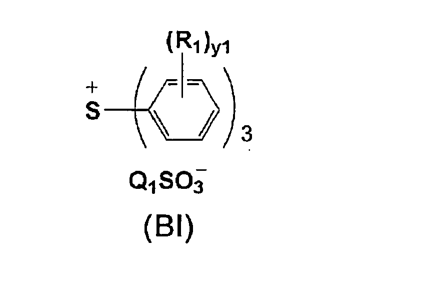

In the general formula (BI) , R₁ represents an alkyl group, an alicyclic hydrocarbon group, a hydroxyl group, a carboxyl group, an alkoxy group, a halogen atom or a phenylthio group, and in case R₁ is present in plural units, R₁'s are mutually same or different, but at least one of R₁' represents a fluorine atom, an alkyl group substituted with a fluorine atom (a fluorine-containing alkyl group), an alicyclic hydrocarbon group substituted with a fluorine atom (a fluorine-containing alicyclic hydrocarbon group), an alkoxy group substituted with a fluorine atom (a fluorine-containing alkoxy group) or a phenylthio group substituted with a fluorine atom (a fluorine-containingphenylthio group) ; y1' seach independently represents 0 to 5; and Q₁ represents an alkyl group substituted with a fluorine atom (a fluorine-containing alkyl group), a cycloalkyl group substituted with a fluorine atom (a fluorine-containing cycloalkyl group), an aryl group substituted with a fluorine atom (a fluorine-containing aryl group) or an aryl group substituted with a fluorinated alkyl group (a fluorinated alkyl group-containing aryl group).

In the general formula (BI), an alkyl group as R₁ is preferably an alkyl group with 1 to 15 carbon atoms, for example a linear or branched alkyl group such as a methyl group, an ethyl group, a propyl group, an n-butyl group, a sec-butyl group, a t-butyl group, a pentyl group, a hexyl group, a heptyl group, an octyl group, a nonyl group, a decyl group, an undecyl group, a dodecyl group, a tridecyl group, or a tetradecyl group. The alkyl group as R₁ may be bonded to a benzene ring via an oxygen atom, a sulfur atom, -C(=O)-, -NH- or a combination thereof.

An alicyclic hydrocarbon group as R₁ is preferably an alicyclic hydrocarbon group with 3 to 15 carbon atoms, such as a cyclopropyl group, a cyclopentyl group, a cyclohexyl group, an adamantly group or a norbornyl group.

An alkoxy group as R₁ can be a group corresponding to the aforementioned alkyl group.

A halogen atom as R₁ can be a fluorine atom, a chlorine atom, a bromine atom or an iodine atom, among which a fluorine atom is preferred.

The alkyl group, alicyclic hydrocarbon group, alkoxy group, phenylthio group and the like as R₁ may have a substituent. The substituent which the alkyl group, alicyclic hydrocarbon group, alkoxy group, phenylthio group and the like as R₁ may have can be, for example, ahalogenatom (fluorineatom, chlorine atom, bromine atom or iodine atom), a hydroxyl group, an alkyl group, an alkoxy group or an alkylthio group.

In the general formula (BI), at least one of R₁'s represents a fluorine atom, an alkyl group substituted with a fluorine atom, an al icyclic hydrocarbon group substituted with a fluorine atom, an alkoxy group substituted with a fluorine atom or a phenylthio group substituted with a fluorine atom.

R₁ is preferably a fluorine atom or an alkyl group substituted with a fluorine atom. Such alkyl group substituted with a fluorine atom can be the aforementioned alkyl group substituted with the fluorine atom, and can be, for example, a perfluoromethyl group, a perfluoroethyl group, a perfluoropropyl group, a perfluorobutyl group, a perfluorohexyl group, or a perfluorooctyl group.

In the general formula (BI), a total number of fluorine atoms contained in (R₁)_{y1} is 4 or more, preferably 4 to 27 and more preferably 4 to 18.

An alkyl group as Q₁ is preferably an alkyl group with 1 to 30 carbon atoms, for example a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, or an eicosyl group.

A cycloalkyl group as Q₁ is preferably a cycloalkyl group with 3 to 30 carbon atoms, such as a cyclopropyl group, a cyclopentyl group, a cyclohexyl group, an adamantly group, a norbornyl group, or a bornyl group.

An aryl group as Q₁ is preferably an aryl group with 6 to 14 carbon atoms, such as a phenyl group, a tolyl group, or a naphthyl group.

The alkyl group, cycloalkyl group or aryl group as Q₁ has a fluorine atom, and a preferred number of fluorine atom is 1 to 20, more preferably 3 to 8.

A fluorinated alkyl group present in the aryl group as Q₁ is preferably a fluorinated alkyl group with 1 to 5 carbon atoms, for example a trifluoromethyl group, a difluoromethyl group, a monofluoromethyl group or a pentafluoroethyl group.

The alkyl group, the cycloalkyl group, the aryl group or the aryl group substituted with a fluorinated alkyl group, as Q₁, may further have a substituent. Such further substituent can be, for example, a halogen atom (excluding a fluorine atom), an alkyl group, an alkoxy group or an alkylthio group.

In the following, specific examples of the compound represented by the general formula (BI) are shown, but the present invention is not limited to such examples.

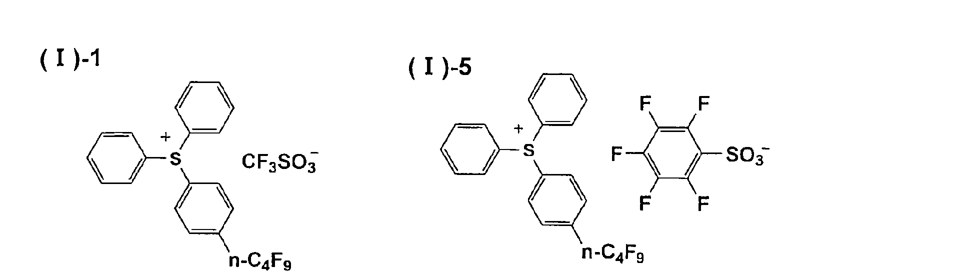

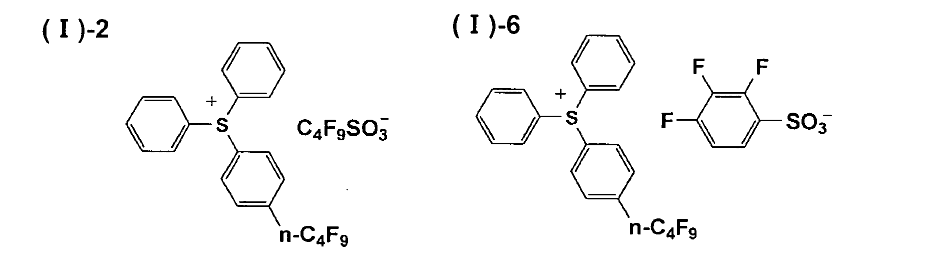

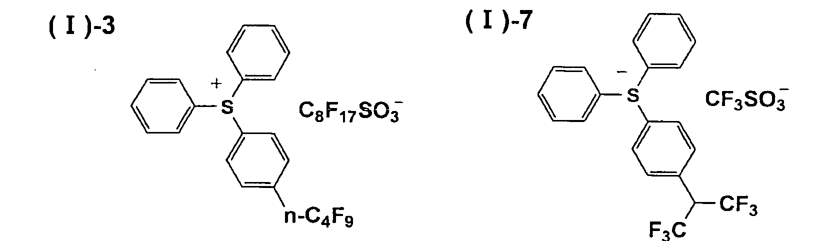

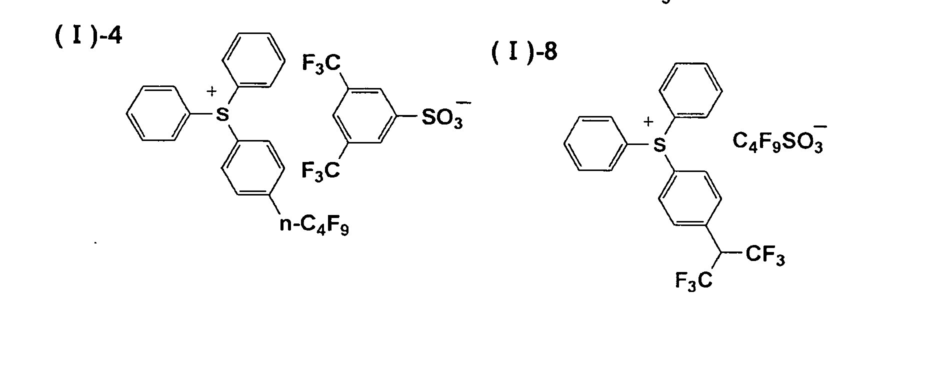

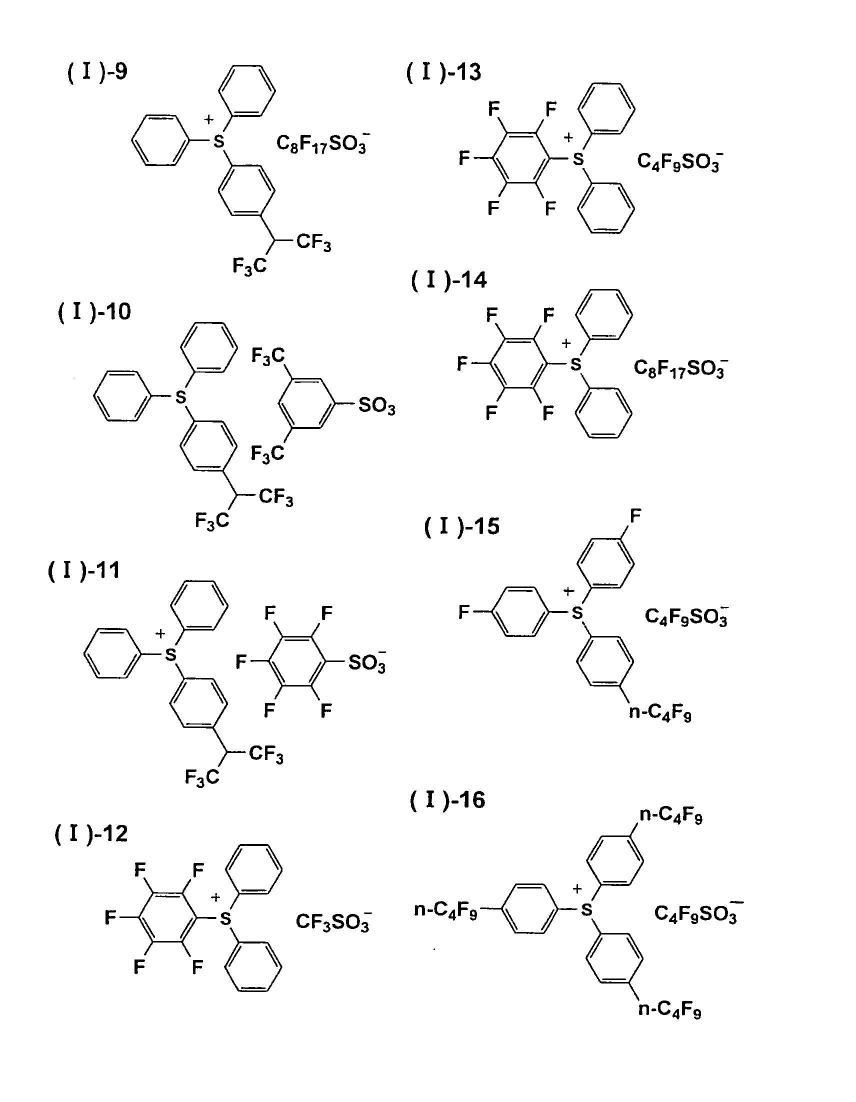

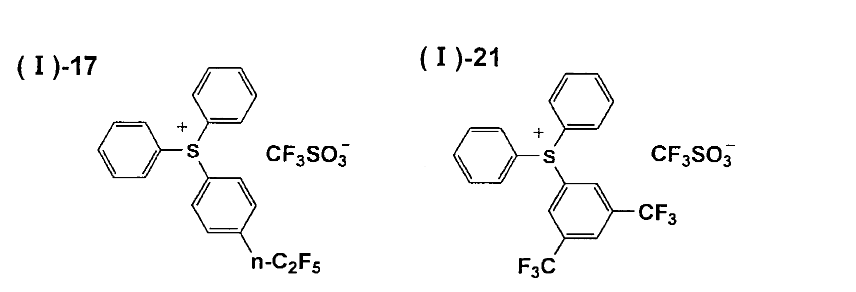

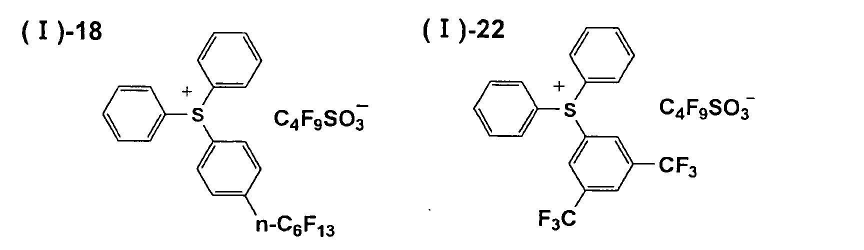

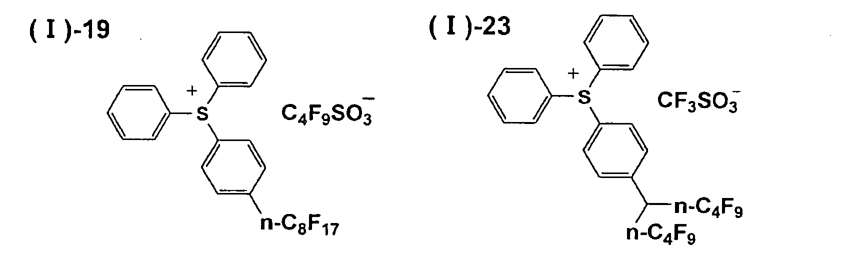

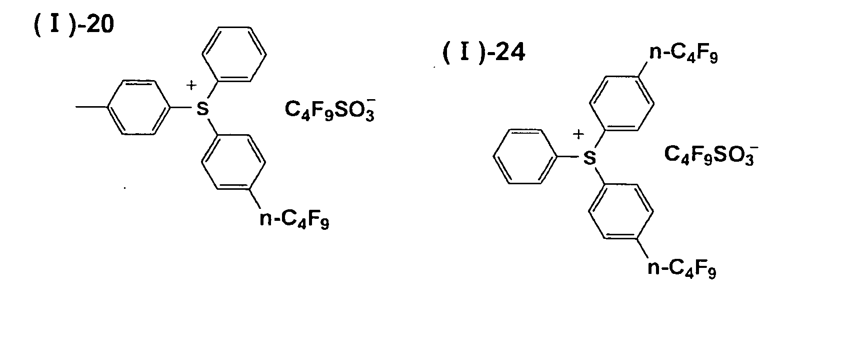

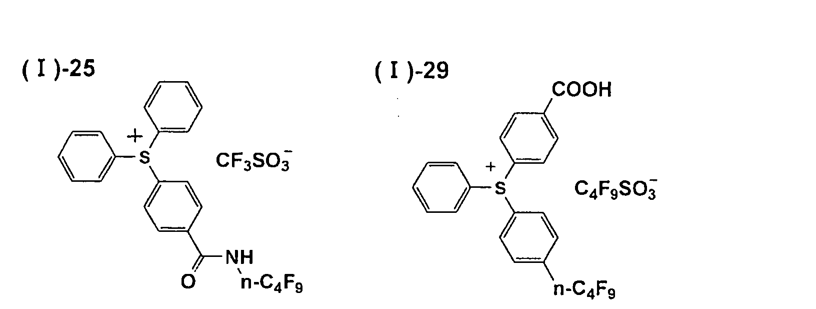

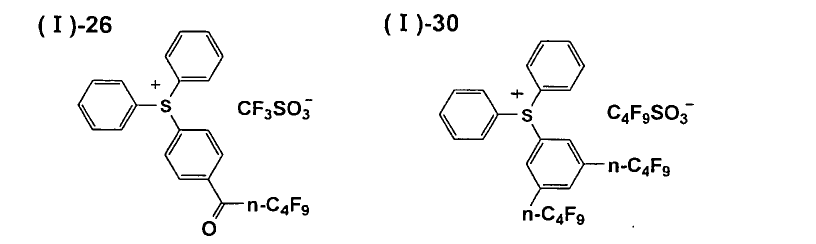

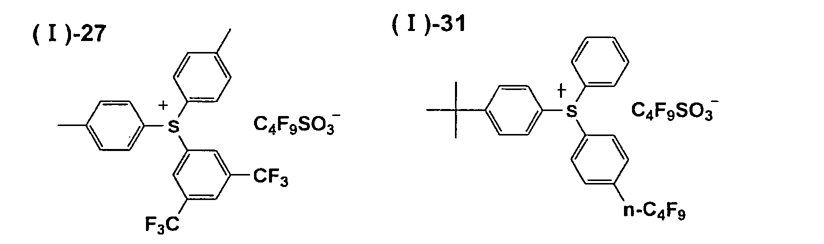

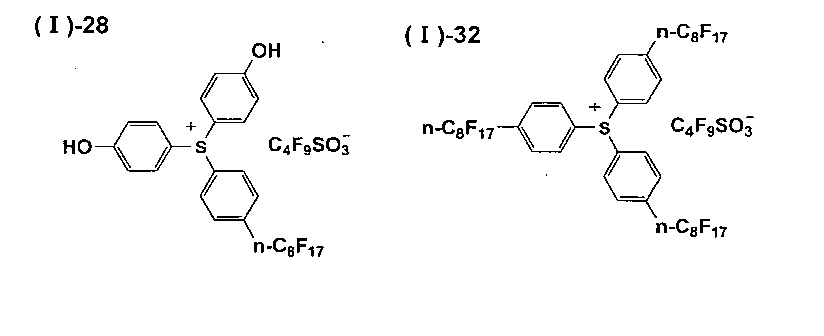

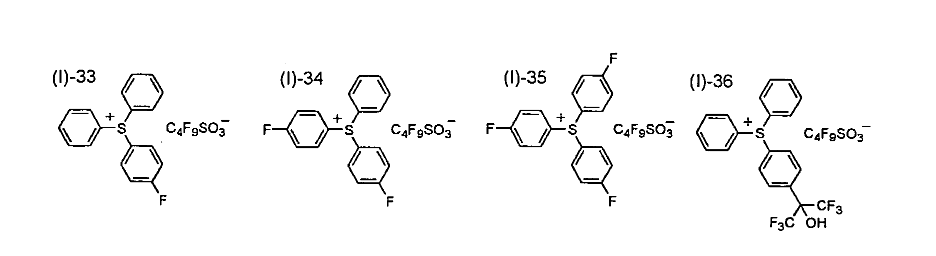

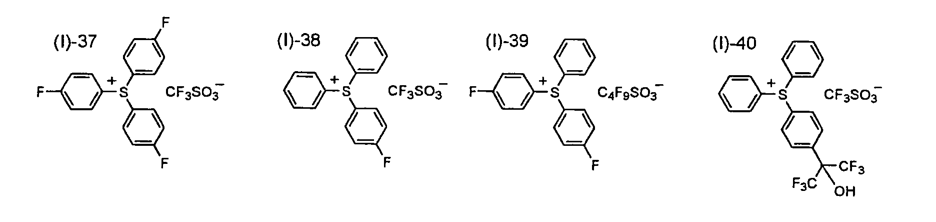

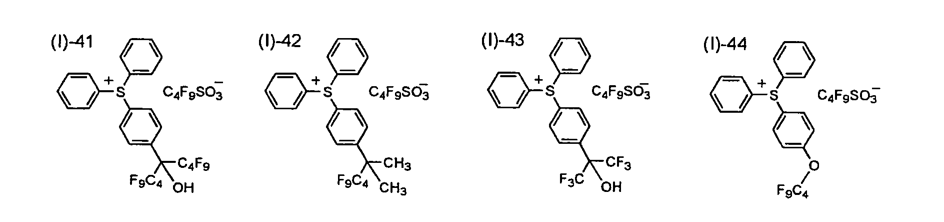

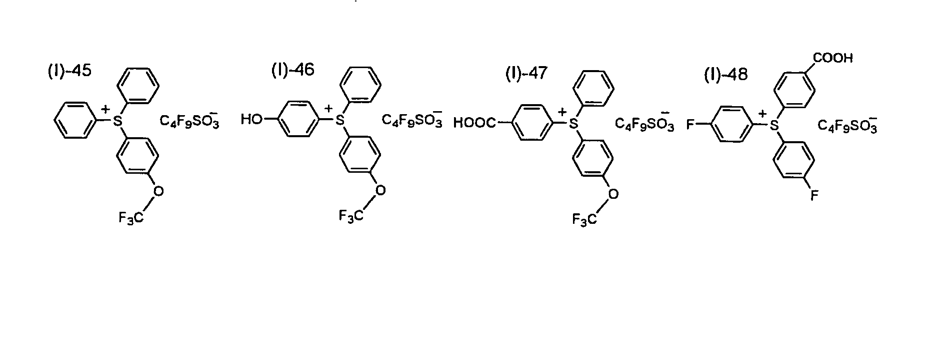

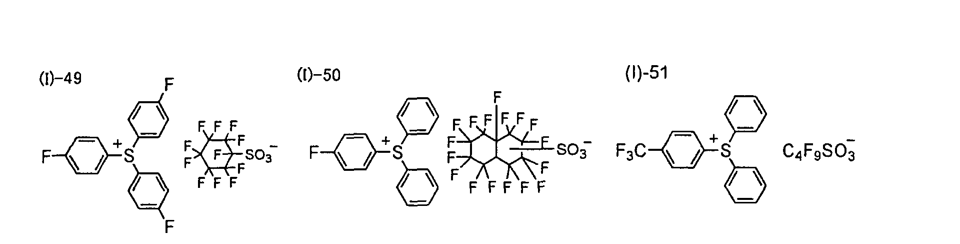

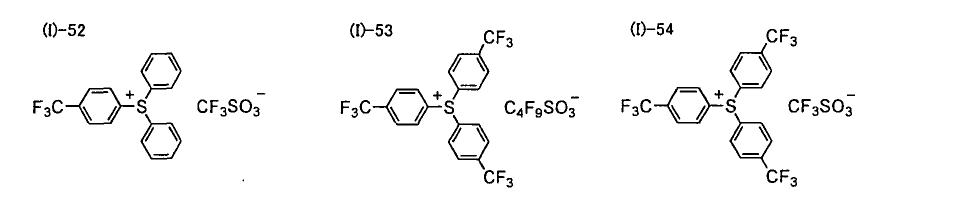

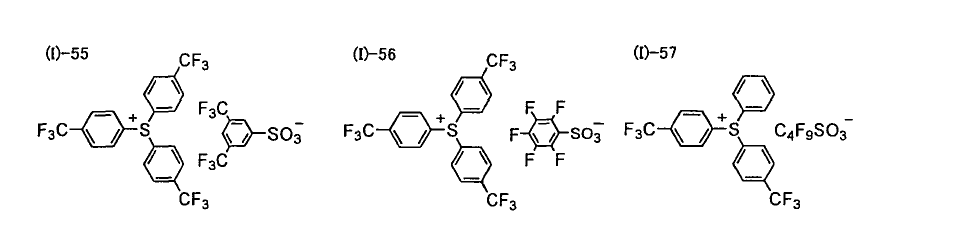

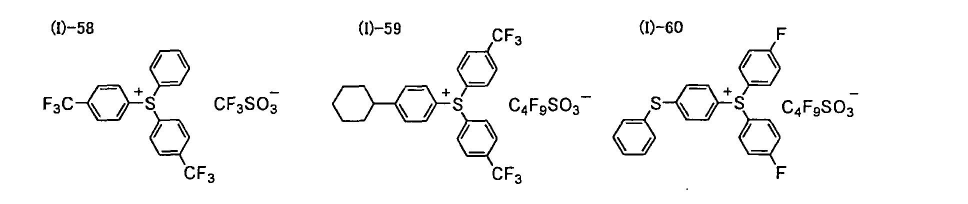

The triarylsulfonium salt containing a fluorine atom in a cation part and generating an aliphatic or aromatic sulfonic acid having a fluorine atom upon irradiation with an actinic ray or a radiation usually has a content of 0.10 to 30 % by weight with respect to all the solids of the resist composition, preferably 0.50 to 20 % by weight.

### [3] (B-2) a sulfonium salt not containing a fluorine atom in a cationpart and generating an aliphatic or aromatic sulfonic acid having a fluorine atom upon irradiation with an actinic ray or a radiation

The positive resist composition of the invention preferably further includes a sulfonium salt not containing a fluorine atom in a cation part and generating an aliphatic oraromaticsulfonicacidhavingafluorineatomuponirradiation with an actinic ray or a radiation.

The sulfonium salt not containing a fluorine atom in a cation part and generating an aliphatic or aromatic sulfonic acid having a fluorine atom upon irradiation with an actinic ray or a radiation is preferably represented by a following general formula (BII) or (BIII).

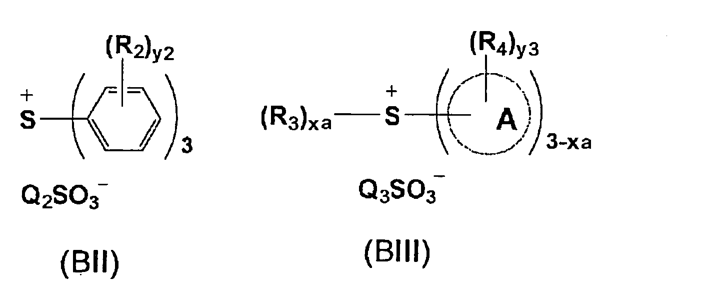

In the general formulas (BII) and (BIII), R₂ represents an alkyl group, an alicyclic hydrocarbon group, a hydroxyl group, a carboxyl group, or an alkoxy group, and, in case R₂ is present in plural units, R₂'s are mutually same or different; Q₂ represents an alkyl group substituted with a fluorine atom (a fluorine-containing alkyl group), a cycloalkyl group substituted with a fluorine atom (a fluorine-containing cycloalkyl group), an aryl group substituted with a fluorine atom (a fluorine-containing aryl group) or an aryl group substituted with a fluorinated alkyl group (a fluorinated alkyl group-containing aryl group); y2's each independently represents 0 to 5; R₃ represents an alkyl group, or an alicyclic hydrocarbon group, and, in case R₃ is present in plural units, R₃'s are mutually same or different, and in case R₃ is present in plural units, R₃'s may be mutually bonded to form a ring; R₄ represents an alkyl group, an alicyclic hydrocarbon group, a hydroxyl group, a carboxyl group, or an alkoxy group, and, in case R₄ is present in plural units, R₄'s are mutually same or different; A represents an aromatic group or a heterocyclic group; Q₃ represents an alkyl group substituted with a fluorine atom (a fluorine-containing alkyl group), a cycloalkyl group substituted with a fluorine atom (a fluorine-containing cycloalkyl group), an aryl group substituted with a fluorine atom (a fluorine-containing aryl group) or an aryl group substituted with a fluorinated alkyl group (a fluorinated alkyl group-containing aryl group); Xa represents 1 to 3; and y3's each independently represents 0 to 5.

In the general formulas (BII) and (BIII), an alkyl group in R₂ to R₄ can be similar to the alkyl group as R₁ in the general formula (BI).

An alicyclic hydrocarbon group in R₂ to R₄ can be similar to the alicyclic hydrocarbon group as R₁ in the general formula (BI).

An alkoxy group in R₂ or R₄ can be similar to the alkoxy group as R₁ in the general formula (BI).

An alkyl group in R₂ or R₄ includes an alkyl group bonded to the benzene ring via an oxygen atom, a sulfur atom, -C (=O) -, -NH- or a combination thereof.

An alkyl group as R₃ includes an alkyl group further bonded to another alkyl group (preferably with 1 to 15 carbon atoms), an aryl group (preferably a phenyl group), or an alicyclic hydrocarbon group (preferably with 6 to 15 carbon atoms) via a carbonyl group, an ether group, a thioether group, a phenylene group or a combination thereof. An alkyl group or an alicyclic hydrocarbon group as R₃ includes those further having a substituent such as a hydroxyl group or an alkoxy group. An alkyl group as R₃ may further have an alicyclic hydrocarbon group or an aryl group as a substituent. An alicyclic hydrocarbon group as R₃ includes those further having an alkyl group, an aryl group or =O as a substituent.

In case R₃ is present in plural units of which two are mutually bonded to form a ring, a group formed by the mutual bonding of two R₃'s can for example be a butylene group.

An aromatic group or a heterocyclic group (including a hetero atom such as oxygen, sulfur or nitrogen in a ring) as Amay be monocyclic or polycyclic, preferably with 5 to 20 carbon atoms, for example a benzene ring, a furan ring, a thiophene ring, a benzofuran ring, a benzothiophene ring, a naphthalene ring, or an anthracene ring.

Q₂ and Q₃ are similar to Q₁ in the general formula (BI).

In the following, specific examples of the compound represented by the general formulas (BII) and (BIII) , but such examples are not restrictive.

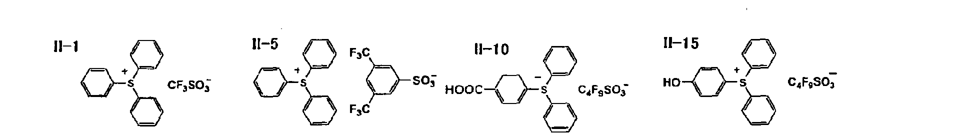

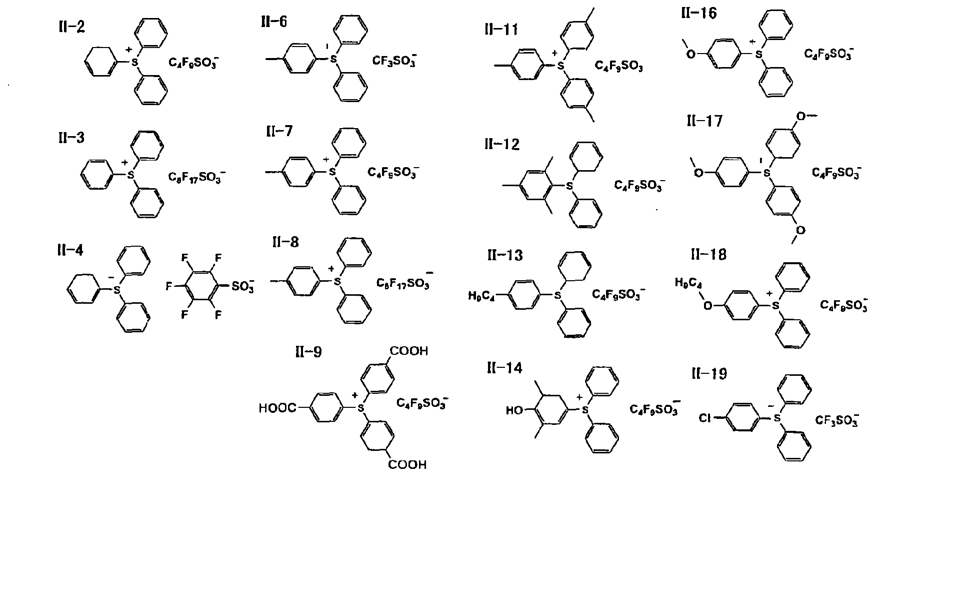

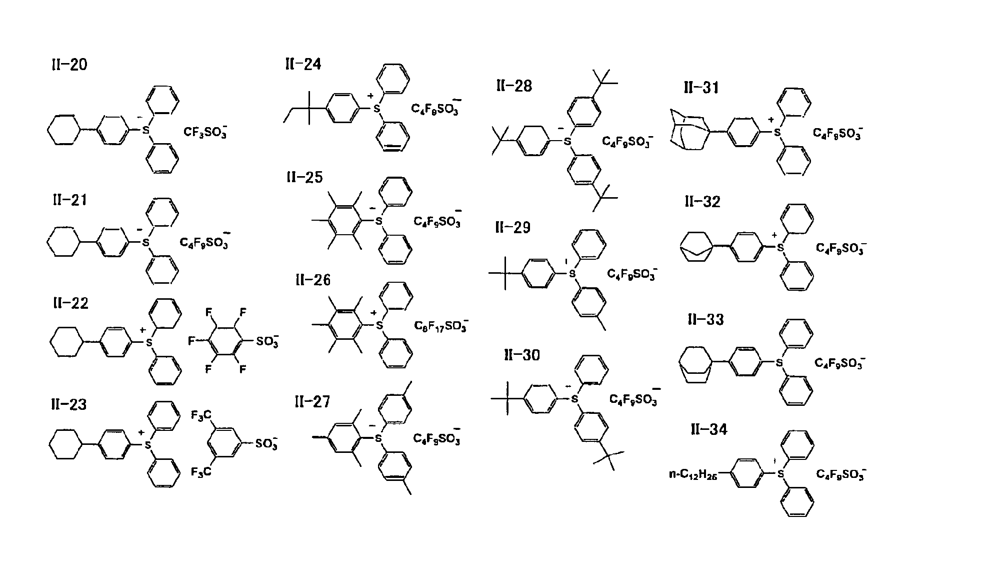

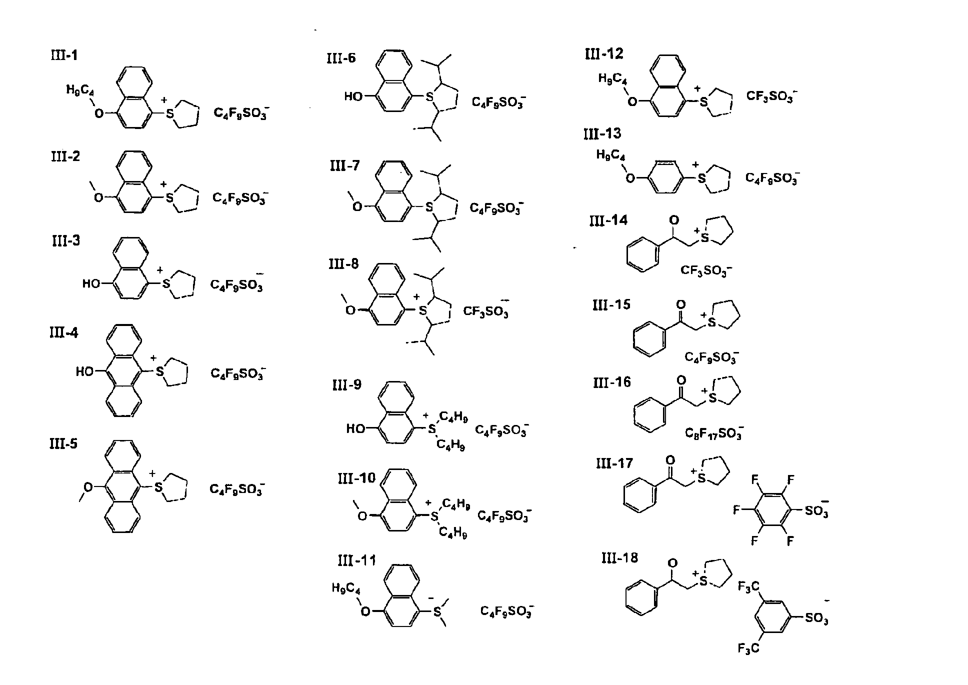

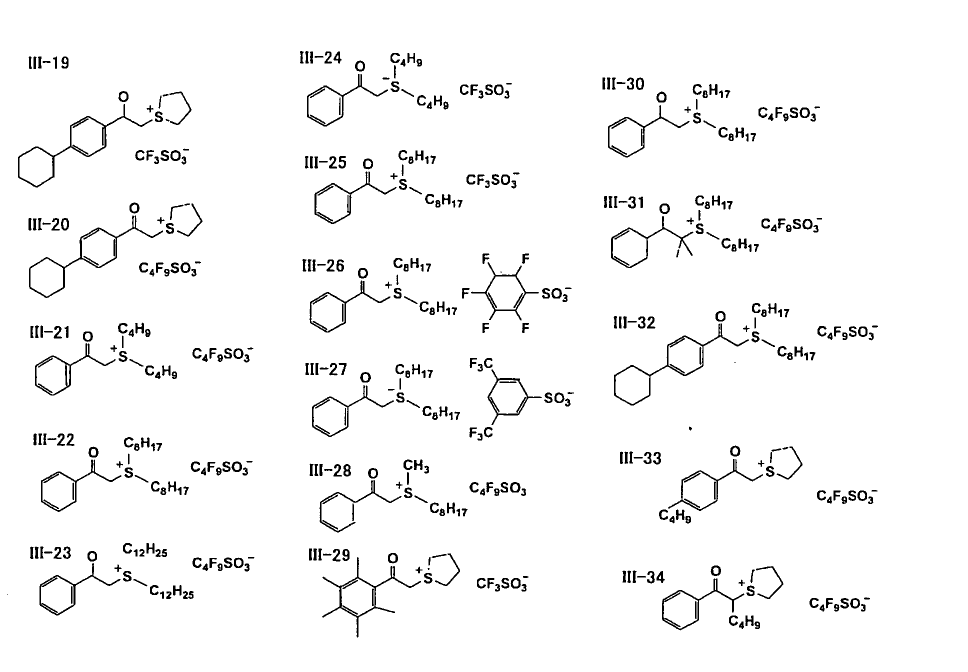

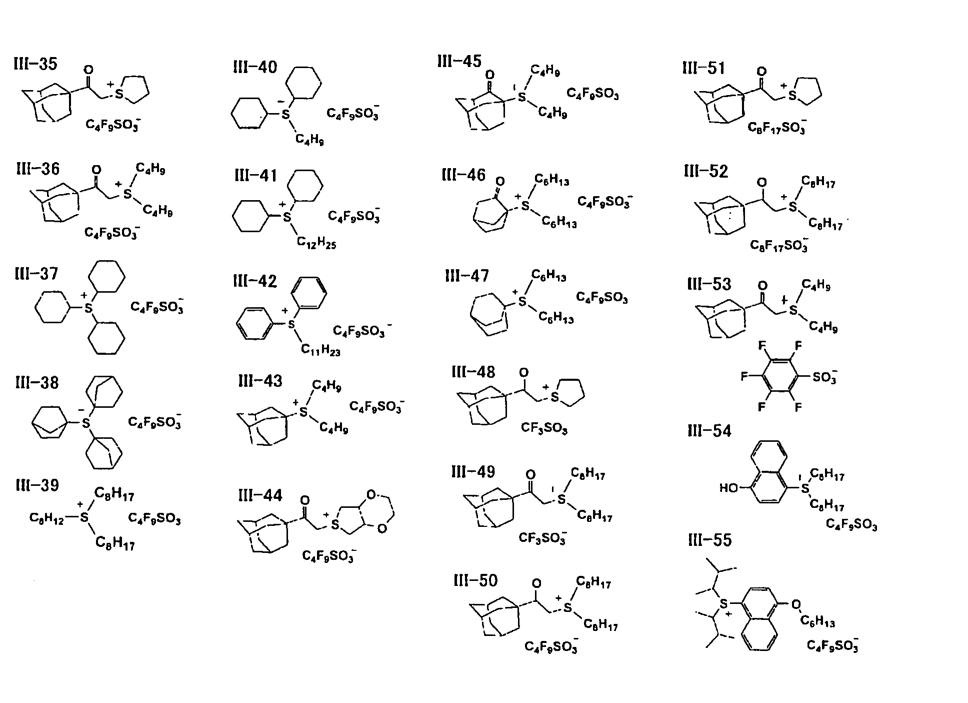

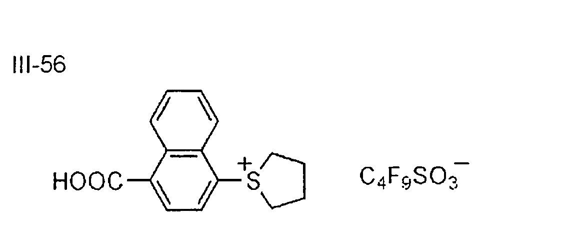

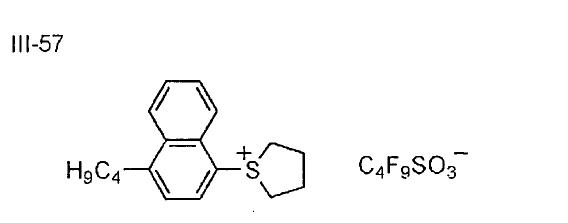

A compound represented by the general formulas (BII) to (BIII) can be synthesized by a known method. A compound represented by the general formula (III), for example a compound III-21, can be obtained by reacting a phenacyl halogenide derivative such as phenacyl bromide with a sulfide in a suitable solvent and without a catalyst or in the presence of a silver catalyst to obtain a phenacyldialkyl sulfonium salt, and executing a salt exchange thereof with a corresponging anion. Other compounds can also be obtained by a similar process from corresponding halogenides and sulfide.

A compound represented by the general formula (BII) can be synthesized in a similar manner as described for a sulfonium compound in JP-A No. 2000-47387, page 36, paragraph [0098], lines 16 to 27.

The sulfonium salt not containing a fluorine atom in a cation part and generating an aliphatic or aromatic sulfonic acid having a fluorine atom upon irradiation with an actinic ray or a radiation generally has a content of 0.10 to 25 % by weight with respect to all the solids of the resist composition, preferably 0.50 to 23 % by weight and more preferably 1.0 to 20 % by weight.

### [4] Another compound generating an acid upon irradiation with an actinic ray or a radiation:

The positive resist composition of the invention may further include another compound capable of generating an acid upon irradiation with an actinic ray or a radiation (photo-acid generator).

Such photo-acid generator can be suitably selected from a photoinitiator of a photocationic polymerization, a photoinitiator of a photoradical polymerization, a photo erasing agent or a photo discoloring agent for a dye, a known compound capable of generating an acid upon irradiation with an actinic ray or a radiation employed in a microphotoresist or the like, and a mixture thereof.

Examples include an onium salt such as a diazonium salt, an ammonium salt, a phosphonium salt, an iodonium salt, a selenonium salt or an arsonium salt, an organic halide, an organic metal/organic halogenide, a photo-acid generator having a protective group of o-nitrobenzyl type, a compound capable of generating a sulfonic acid by a photolysis represented by an iminosulfonate, and a disulfone compound.

There can also be employed a compound in which such group capable of generating an acid upon irradiation with an actinic ray or a radiation is introduced in a main chain or a side chain of a polymer, such as those described in USP No. 3,849,137, GP No. 3914407, JP-A Nos. 63-26653, 55-164824, 62-69263, 63-146038, 63-163452, 62-153853, and 63-146029.

Also there canbe employed a compound capable of generating an acid by a light as described in USP No. 3,779,778 and EP No. 126,712.

Among such other compounds capable of generating an acid under a decomposition upon irradiation with an actinic ray or a radiation, an effectively usable one will be explained in the following.

### (1) An iodonium salt represented by a following general formula (PAG1):

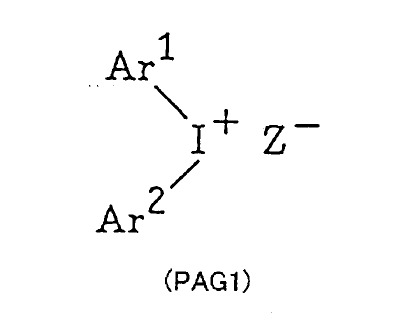

In the formula, Ar¹ and Ar² each independently represents an aryl group. A preferred substituent on Ar¹ and Ar² can be, for example, an alkyl group, a cycloalkyl group, an aryl group, an alkoxy group, a nitro group, a carboxyl group, an alkoxycarbonyl group, a hydroxyl group, a mercapto group or a halogen atom.

Z- represents a counter anion, for example a perfluoroalkanesulfonate anion such as BF₄⁻, AsF₆⁻, PF₆⁻, SbF₆⁻, SiF₆²⁻, ClO₄⁻, or CF₃SO₃⁻, a condensed polynucleic aromatic sulfonate anion such as a pentafluorobenzenesulfonate anion or a naphthalene-1-sulfonate anion, an anthraquinonesulfonate anion, or a sul fonic acid group-containing dye, but such examples are not restrictive.

Also Ar¹ and Ar² may be bonded via a single bond or a substituent.

Specific examples include following compounds, but such examples are not restrictive.

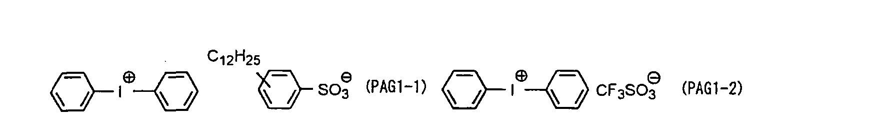

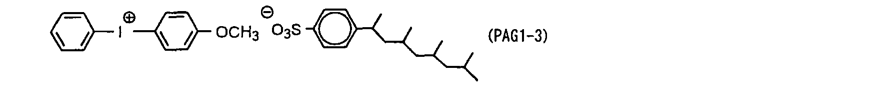

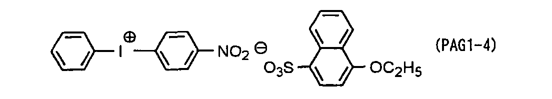

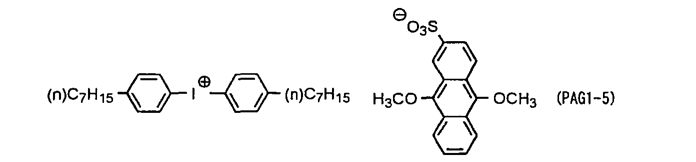

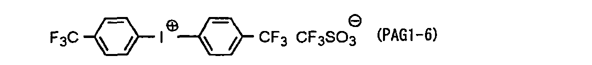

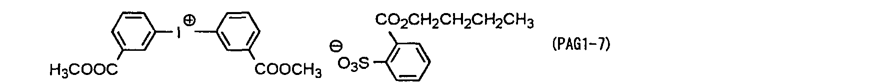

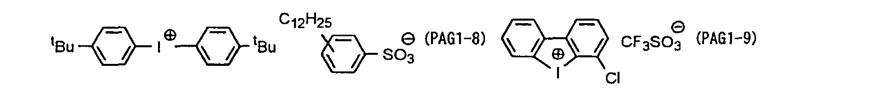

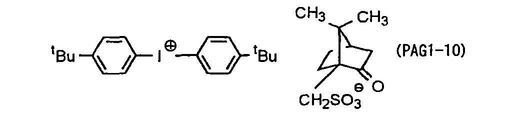

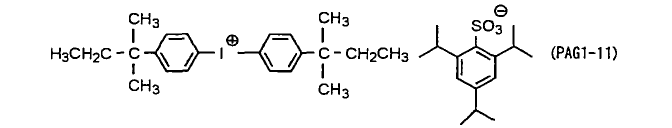

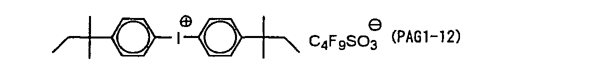

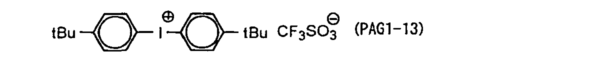

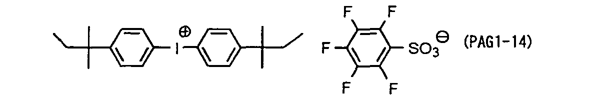

The onium salts represented by the general formula (PAG1) are already known and can be synthesized by methods described for example in USP Nos. 2, 807, 648 and 4,247,473, and JP-A No. 53-101, 331.

### (2) A disulfone derivative represented by a following general formula (PAG3) or an iminosulfonate derivative represented by a general formula (PAG4):

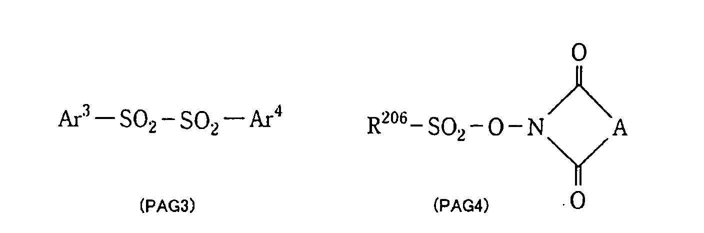

In the formulas, Ar³ and Ar⁴ each independently represents an aryl group.

R²⁰⁶ represents an alkyl group or an aryl group; and A represents an alkylene group, an alkenylene group or an arylene group.

Specific examples are shown in the following, but the invention is not limited to such examples.

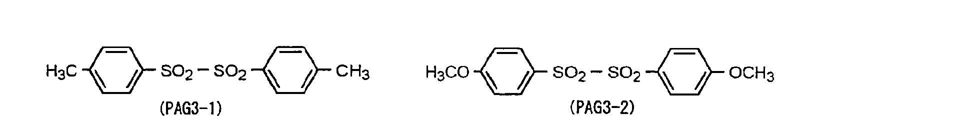

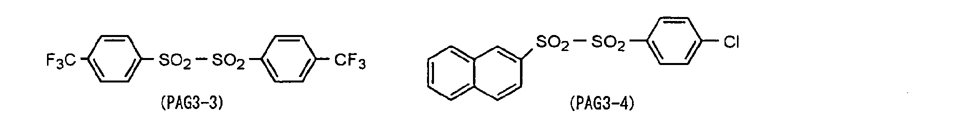

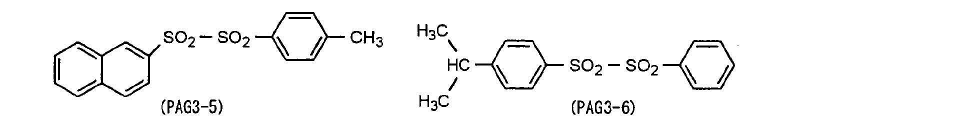

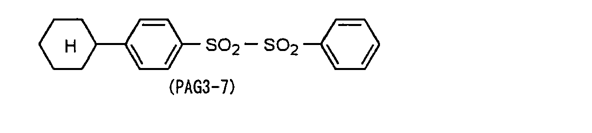

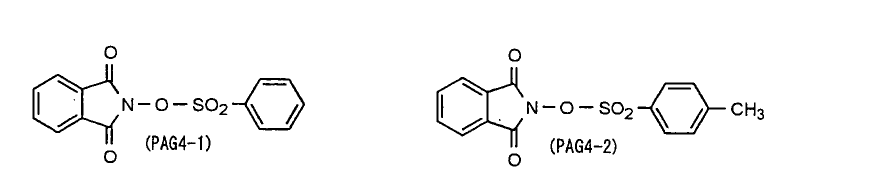

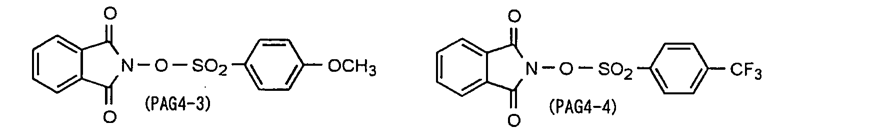

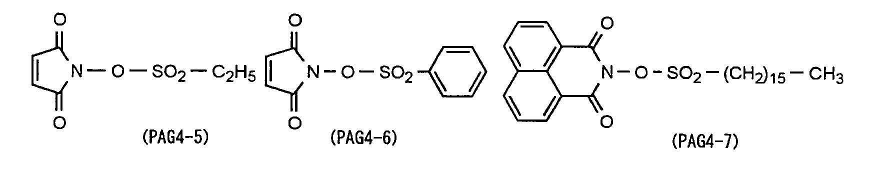

### (3) A diazosulfone derivative represented by a following general formula (PAG5):

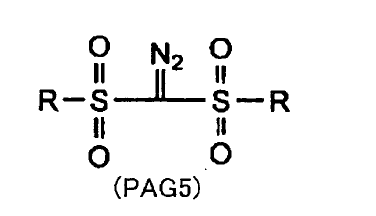

In the formula, R represents an alkyl group, a cycloalkyl group or an aryl group.

Specific examples are shown in the following, but the invention is not limited to such examples.

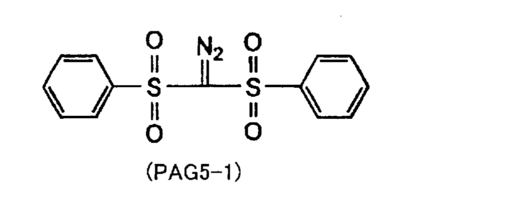

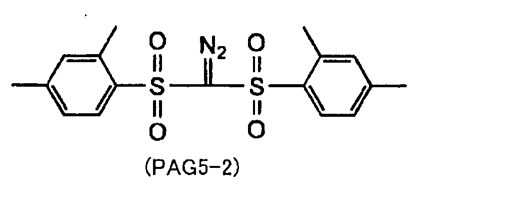

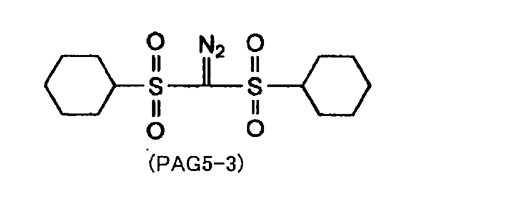

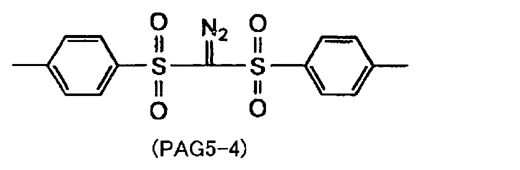

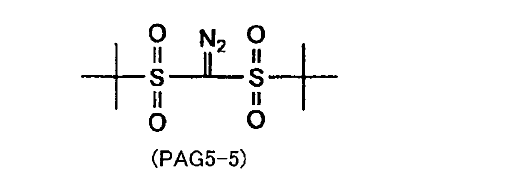

The another compound capable of generating an acid upon irradiation with an actinic ray or a radiation usually has a content of 0.10 to 25 % by weight with respect to all the solids in the resist composition, preferably 0.50 to 23 % by weight and more preferably 1.0 to 20 % by weight.

### [5] (D) Organic solvent

The positive resist composition of the invention preferably utilizes, as a solvent, a mixture or two or more organic solvents. The mixed solvent can contain at least a solvent selected from propylene glycol monoalkyl ether carboxylate (also called solvent of group A), and at least a solvent selected from propylene glycol monoalkyl ether, alkyl lactate and alkyl alkoxypropionate (also called solvent of group B) and/or at least a solvent selected from γ-butyrolactone, ethylene carbonate, propylene carbonate and cyclohexanone (also called solvent of group C). Thus, as the mixed solvent, there can be employed a combination of the solvent of group A and the solvent of group B, a combination of the solvent of group A and the solvent of group C, or a combination of the solvent of group A, the solvent of group B, and the solvent of group C.

As propylene glycol monoalkyl ether carboxylate, there is preferred propylene glycol monomethyl ether acetate, propylene glycol monomethyl ether propionate, propylene glycol monoethyl ether acetate, or propylene glycol monoethyl ether propionate.

As propylene glycol monoalkyl ether, propylene glycol monomethyl ether, or propylene glycol monoethyl ether is preferred. As alkyl lactate, methyl lactate, or ethyl lactate is preferred. As alkyl alkoxypropionate, there is preferred ethyl 3-ethoxypropionate, methyl 3-methoxypropionate, ethyl 3-methoxypropionate, or methyl 3-ethoxypropionate.

The solvent of group A and the solvent of group B are used in a weight ratio (A:B) preferably from 90:10 to 15:85, more preferably from 85:15 to 20:80, and further preferably from 80:20 to 25:75.

The solvent of group A and the solvent of group C are used in a weight ratio (A:C) preferably from 99.9: 0.1 to 75:25, more preferably from 99:1 to 80:20, and further preferably from 97:3 to 85:15.

In case the solvents of three types are combined, the solvent of group C is preferably employed in a proportion of 0.1 to 25 % by weight with respect to all the solvents, more preferably 1 to 20 % by weight and further preferably 3 to 17 % by weight.

In the invention, solids of the composition including the aforementioned components are dissolved in the mixed solvent preferably with a solid concentration of 3 to 25 % by weight, more preferably 5 to 22 % by weight and further preferably 7 to 20 % by weight.

In the invention, examples of a preferred combination of the mixed solvent containing propylene glycol monoalkyl ether carboxylate include:
propylene glycol monomethyl ether acetate + propylene glycol monomethyl ether;
propylene glycol monomethyl ether acetate + ethyl lactate;
propylene glycol monomethyl ether acetate + ethyl 3-ethoxypropionate;
propylene glycol monomethyl ether acetate + γ-butyrolactone;
propylene glycol monomethyl ether acetate + ethylene carbonate;
propylene glycol monomethyl ether acetate + propylene carbonate;
propylene glycol monomethyl ether acetate + cyclohexanone;
propylene glycol monomethyl ether acetate + propylene glycol monomethyl ether + γ-butyrolactone;
propylene glycol monomethyl ether acetate + ethyl lactate + γ-butyrolactone;
propylene glycol monomethyl ether acetate + ethyl 3-ethoxypropionate + γ-butyrolactone;
propylene glycol monomethyl ether acetate + propylene glycol monomethyl ether + ethylene carbonate;
propylene glycol monomethyl ether acetate + ethyl lactate + ethylene carbonate;
propylene glycol monomethyl ether acetate + ethyl 3-ethoxypropionate + ethylene carbonate;
propylene glycol monomethyl ether acetate + propylene glycol monomethyl ether + propylene carbonate;
propylene glycol monomethyl ether acetate + ethyl lactate + propylene carbonate;
propylene glycol monomethyl ether acetate + ethyl 3-ethoxypropionate + propylene carbonate; and
propylene glycol monomethyl ether acetate + propylene glycol monomethyl ether + cyclohexanone.

Particularly preferred combinations of the solvents include:
propylene glycol monomethyl ether acetate + propylene glycol monomethyl ether;
propylene glycol monomethyl ether acetate + propylene glycol monomethyl ether + γ-butyrolactone;
propylene glycol monomethyl ether acetate + ethyl lactate + γ-butyrolactone;
propylene glycol monomethyl ether acetate + ethyl 3-ethoxypropionate + γ-butyrolactone;
propylene glycol monomethyl ether acetate + propylene glycol monomethyl ether + ethylene carbonate;
propylene glycol monomethyl ether acetate + ethyl lactate + ethylene carbonate;
propylene glycol monomethyl ether acetate + ethyl 3-ethoxypropionate + ethylene carbonate;
propylene glycol monomethyl ether acetate + propylene glycol monomethyl ether + propylene carbonate;
propylene glycol monomethyl ether acetate + ethyl lactate + propylene carbonate;
propylene glycol monomethyl ether acetate + ethyl 3-ethoxypropionate + propylene carbonate;
propylene glycol monomethyl ether acetate + propylene glycol monomethyl ether + cyclohexanone; and
propylene glycol monomethyl ether acetate + cyclohexanone.

Another solvent may be added to each of the aforementioned mixed solvents. An amount of such another solvent is generally 30 parts by weight or less with respect to 100 parts by weight of the mixed solvent of the invention. Such another solvent can be, in addition to the solvents described above as necessary for the mixed solvents, for example ethylene dichloride, cyclopentanone, methyl ethyl ketone, toluene, N,N-dimethylformamide, dimethyl sulfoxide, N-methyl pyrrolidone or tetrahydrofuran.

The positive resist composition preferably employs the aforementioned mixed solvent, but can also employ a single solvent such as propylene glycol monomethyl ether acetate, propylene glycol monomethyl ether or cyclohexanone if necessary.

The positive resist composition has a solid concentration therein preferably of 5 to 15 % by weight, more preferably 7 to 11 % by weight.

### [6] (C) Nitrogen-containing basic compound

In the following, a nitrogen-containing basic compound (C) which can be advantageously employed in the positive resist composition of the invention will be explained. The (C) nitrogen-containing basic compound can be an organic amine, a basic ammonium salt or a basic sulfonium salt, which does not cause a sublimation or does not deteriorate the performances of the resist.

Among such nitrogen-containing basic compounds, an organic amine is preferred in an excellent imaging property.

For example, there can be employed compounds described inJP-ANos. 63-149640, 5-249662, 5-127369, 5-289322, 5-249683, 5-289340, 5-232706, 5-237282, 6-242605, 6-242606, 6-266100, 6-266110, 6-317902, 7-120929, 7-146558, 7-319163, 7-508840, 7-333844, 7-219217, 7-92678, 7-28247, 8-22120, 8-110638, 8-123030, 9-274312, 9-166871, 9-292708, 9-325496, JP-T No. 7-508840, USP Nos. 5,525,453, 5,629,134, and 5,667,938.

The nitrogen-containing basic compound can preferably be 1,5-diazabicyclo[4.3.0]-5-nonene, 1,8-diazabicyclo[.5.4.0]-7-undecene, 1,4-diazabicyclo[2.2.2]-octane, 4-dimethylaminopyridine, 1-naphthylamine, piperidine, hexamethylenetetramine, an imidazole, ahydroxypyridine, apyridine, 4,4'-diaminodiphenyl ether, pyridinium p-toluenesulfonate, 2,4,6-trimethylpyridinium p-toluenesulfonate, tetramethylammonium p-toluenesulfonate, tetrabutylammonium lactate, triethylamine or tributyl amine.

Among these, there is preferred an organic amine such as 1,5-diazabicyclo[4.3.0]-5-nonene, 1,8-diazabicyclo[5.4.0]-7-undecene, 1,4-diazabicyclo[2.2.2]-octane, 4-dimethylaminopyridine, 1-naphthylamine, piperidine, hexamethylenetetramine, an imidazole, a hydroxypyridine, a pyridine, 4,4'-diaminodiphenyl ether, triethylamine or tributyl amine.

(C) The nitrogen-containing basic compound generally has a content of 0.001 to 10 % by weight with respect to all the solids of the positive resist composition, preferably 0.001 to 5 % by weight and more preferably 0.001 to 0.5 % by weight.

(D) The basic compound may be employed singly or in a combination of two or more kinds.

### [7] (E) Fluorinated and/or silicone surfactant

The positive resist composition of the invention preferably further contain either or two or more of (E) a fluorinated and/or silicone surfactant (a fluorinated surfactant, a silicone surfactant or a surfactant containing a fluorine atom and a silicon atom).

The positive resist composition of the invention, by including the surfactant (E), can provide a resist pattern with little defects in adhesion and development with a satisfactory sensitivity and a satisfactory resolution, in case of employing an exposure source of a wavelength of 250 nm or less, particularly 220 nm or less.

Such surfactant (E) can be those described in JP-A Nos. 62-36663, 61-226746, 61-226745, 62-170950, 63-34540, 7-230165, 8-62834, 9-54432, 9-5988, and 2002-277862, USP Nos. 5,405,720, 5,360,692, 5,529,881, 5,296,330, 5, 436, 098, 5,576,143, 5, 294, 511 and 5, 824, 451, and following commercially available surfactants can also be utilized.

The usable commercially available surfactants include fluorinated surfactants and silicone surfactants such as Eftop EF301 and EF302 (manufactured by Shin-Akita Kasei K.K.), Florad FC 430 and 431 (manufactured by Sumitomo 3M, Inc.), Megafac F171, F173, F176, F189, R08 (manufactured by Dainippon Inks and Chemicals, Inc.), Surflon S382, SC101, 102, 103, 104, 105, 106 (manufactured by Asahi Glass Co., Ltd.) and Troysol S-366 (manufactured by Troy Chemical Industries, Inc.). Also a organosiloxane polymer KP-341 (manufactured by Shin-Etsu Chemical Industries Co., Ltd.) can be used as a silicone surfactant.

In addition to these known ones, there can also be employed a surfactant using a polymer having a fluoro aliphatic group, which is derived from a fluoro aliphatic compound manufactured by a telomerization method (also called telomer method) or by an oligomerization method (also called oligomer method). The fluoro aliphatic compound can be synthesized by a method described in JP-A No. 2002-90991.

The polymer having a fluoro aliphatic group is preferably a copolymer of a monomer having a fluoro aliphatic group and (poly(oxyalkylene)) acrylate and/or (poly(oxyalkylene)) methacrylate, either having an irregular distribution or being block copolymerized. Also the poly (oxyalkylene) group can be a poly(oxyethylene) group, a poly(oxypropylene) group or a poly (oxbutylene) group, and there can also be employed a unit having alkylenes of different chain lengths within a same unit such as a poly(oxyethylene-oxypropylene-oxyethylene block-connected) group or a poly(oxyethylene-oxypropylene block-connected) group. Also the copolymer of a monomer having a fluoro aliphatic group and (poly(oxyalkylene)) acrylate (or methacrylate) is not limited to a binary copolymer but can also be a ternary or higher copolymer in which monomers having two or more different fluoro aliphatic groups and two or more different (poly (oxyalkylene)) acrylates (or methacrylates) are simultaneously copolymerized.

Examples of the commercially available surfactant include Megafac F178, F470, F473, F475, F476 and F472 (manufactured by Dainippon Inks and Chemicals, Inc.). There can also be employed a copolymer of an acrylate (or methacrylate) having a C₆F₁₃ group and (poly (oxyalkylene) ) acrylate (or methacrylate) , a copolymer of an acrylate (or methacrylate) having a C₆F₁₃ group, (poly(oxyethylene)) acrylate (or methacrylate), and (poly (oxypropylene) ) acrylate (or methacrylate) , a copolymer of an acrylate (or methacrylate) having a C₈F₁₇ group and (poly(oxyalkylene)) acrylate (or methacrylate), a copolymer of an acrylate (or methacrylate) having a C₈F₁₇ group, (poly(oxyethylene)) acrylate (or methacrylate), and (poly(oxypropylene)) acrylate (or methacrylate).

(E) An amount of the surfactant is preferably 0.0001 to 2 % by weight with respect to the entire positive resist composition (excluding solvents) , more preferably 0. 001 to 1 % by weight.

The positive resist composition of the invention may contain, if necessary, a low molecular acid-decomposable compound having a molecular weight of 2,000 or less, having a group decomposable by an action of an acid and showing an increase in an alkali solubility by an action of an acid.

As such low molecular acid-decomposable compound, there can be employed an aliphatic compound having an acid-decomposable group such as a cholic acid derivative, a dehydrocholic acid derivative, a deoxycholic acid derivative, a lithocholic acid derivative, an ursocholic acid derivative or an abietic acid derivative, and an aromatic compound having an acid-decomposable group such as a naphthalene derivative, as described in Proc. SPIE, 2724, 355 (1996) , JP-A No. 8-15865, USPNos. 5, 310, 619 and 5, 372, 912, and J. Photopolym. Sci . , Tech . , Vol. 10, No. 3,511(1997).

Also a low-molecular acid-decomposable dissolution inhibitor described in JP-A No. 6-51519 can be utilized within an extent not deteriorating the transmittance at 220 nm, and a 1,2-naphthoquinone diazide compound can also be utilized.

In case of employing such low-molecular acid decomposable dissolution inhibitor in the positive resist composition of the invention, it is usually employed with a content of 0.5 to 50 % by weight with respect to all the solids in the resist composition, preferably 0. 5 to 40 % byweight, furtherpreferably 0.5 to 30 % by weight and particularly preferably 0.5 to 20.0 % by weight.

An addition of such low-molecular acid-decomposable dissolution inhibitor improves not only the aforementioned defects in development but also a dry etching resistance.

The positive resist composition of the invention may further include, if necessary, a dissolution accelerator to the developer, an antihalation agent, a plasticizer, a surfactant, a photosensitizer, an adhesion promoter, a crosslinking agent, a photobase generating agent etc.

A dissolution accelerator to the developer, employable in the invention, can be a low-molecular compound with a molecular weight of 1000 or less, such as a compound having two or more phenolic hydroxyl groups as described in JP-A No. 3-206458, a naphthol such as 1-naphthol, a compound having at least one carboxyl group, a carboxylic acid anhydride, a sulfonamide compound or a sulfonylimide compound.

Such dissolution accelerator is preferably employed in an amount of 30 % by weight or less with respect to all the weight (solids) of the composition, more preferably 20 % by weight or less.

A preferred antihalation agent is a compound capable of efficiently absorbing the irradiating radiation, for example a substituted benzene such as fluorene, 9-fluorenone or benzophenone; or a polycyclic aromatic compound such as anthracene, anthracene-9-methanol, anthracene-9-carboxyethyl, phenanthrene, perylene, orazilene. Among these, a polycyclic aromatic compound is particularly preferable. Such antihalation agent reduces a reflected light from the substrate and an influence of multiple reflections within the resist film, thereby reducing the standing waves.

Also a photosensitizer can be added for improving an acid generating rate by an exposure. Examples of the preferred photosensitizer include benzophenone, p,p'-tetramethyldiaminobenzophenone, 2-chlorothioxanthone, anthrone, 9-ethoxyanthracene, pyrene, phenothiazine, benzyl, benzoflavin, acetophenone, phenanthrene, benzoquinone, anthraquinone and 1,2-naphthoquinone, but such examples are not restrictive. These photosensitizers can also be used as the antihalation agent.

### <Method of use>

The positive resist composition of the invention is used by dissolving the aforementioned components in (D) organic solvent, then filtering the solution with a filter and coating on a predetermined substrate.

More specifically, the positive resist composition is coated on a substrate for example used for producing an integrated circuit (such as a silicon covered with silicon dioxide) , by a suitable coatingmethodwith a spinner or a coater, and is heated to form a resist film.

Then the resist film is exposed through a predetermined mask, heated and developed. In this manner, a satisfactory resist pattern can be obtained. An exposing light is a far ultraviolet light, preferably of 250 nm or less, more preferably 220 nm or less. It can more specifically be an actinic ray of an KrF excimer laser (248 nm), an ArF excimer laser (193 nm) or an F₂ excimer laser (157 nm), or a radiation such as an X-ray or an electron beam.

As an alkali developer for the positive resist composition, there can be employed an alkaline aqueous solution of an inorganic alkali such as sodiumhydroxide, potassiumhydroxide, sodium carbonate, sodium silicate, sodium metasilicate, or ammonia solution; a primary amine such as ethylamine or n-propylamine; a secondary amine such as diethylamine or di-n-butylamine; a tertiary amine such as triethylamine or methyldiethylamine; an alcohol amine such as dimethylethanol amine, or triethanolamine; a quaternary ammonium salt such as tetramethylammonium hydroxide or tetraethylammonium hydroxide; or a cyclic amine such as pyrrole or piperidine.

Also an alcohol or a surfactant may be added in a suitable amount to the alkaline aqueous solution.

The alkali developer generally has an alkali concentration of 0.1 to 20 % by weight, and a pH value of 10.0 to 14.0.

### [Examples]

In the following, the present invention will be clarified further by examples, but the present invention is not limited to such examples.

### Synthesis example 1 (synthesis of resin (1))

2-adamantyl-2-propylmethacrylate, dihydroxyadamantane methacrylate, norbornanelactone acrylate and succinic monoethylene glycol methacrylate were charged in a proportion of 30/20/40/10, dissolved in propylene glycol monomethyl ether acetate/propylene glycol monomethyl ether = 60/40, to obtain 450 g of a solution of a solid concentration of 22 % by weight. The solution was added with a polymerization initiator V-601, manufactured by Wako Pure Chemicals Industries Inc., by 9 % by mole and was dropwise added, over 6 hours and in a nitrogen atmosphere, to 50 g of a mixed solution of propylene glycol monomethyl ether acetate/propylene glycol monomethyl ether = 60/40, heated to 80°C. After the addition, the reaction liquid was agitated for 2 hours. After the reaction, the reaction liquid was cooled to the room temperature and poured into 5 L of a mixed solvent of hexane/ethyl acetate = 9/1, and precipitated white powder was separated by filtering to obtain the desired resin (1).

It had a polymer composition (molar ratio) of a/b/c/d = 31/20/39/10 determined by ¹³CNMR, a weight-averaged molecular weight of 8010 determined by a GPC measurement in a conversion to polystyrene, and a degree of dispersion of 2.1.

Resins (1) to (17) were synthesized in a similar manner as the synthesis example 1.

Structures of the resins (1) to (17) are shown in the following.

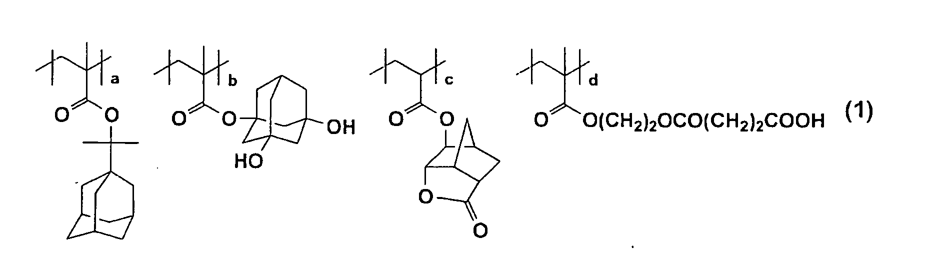

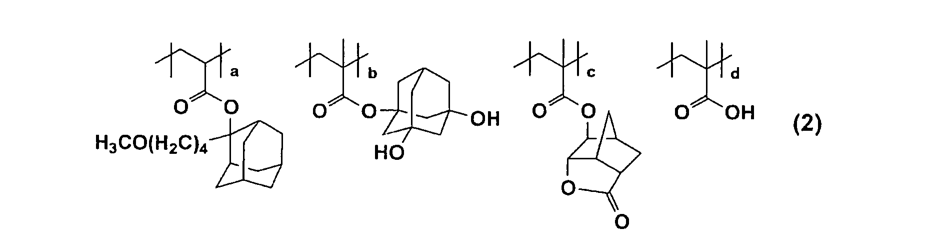

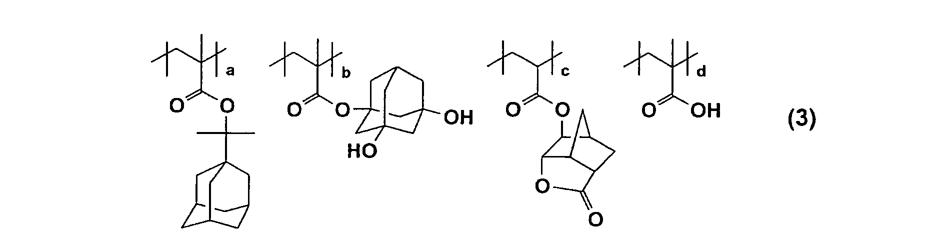

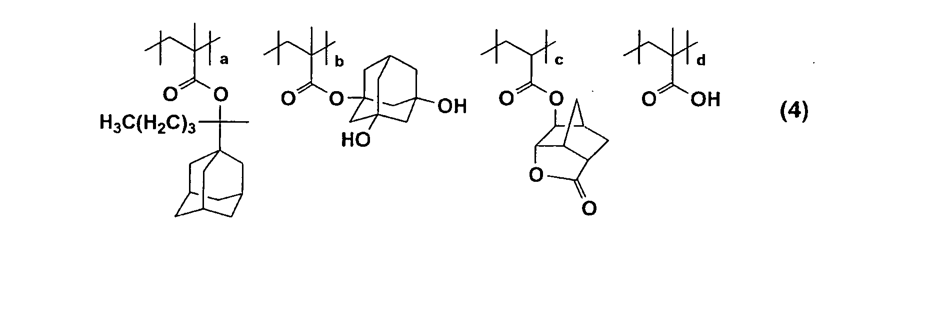

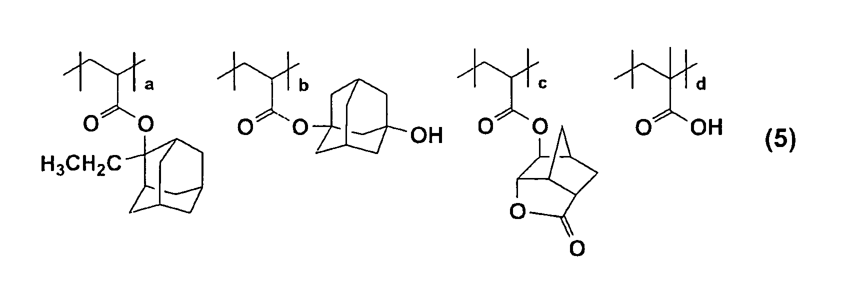

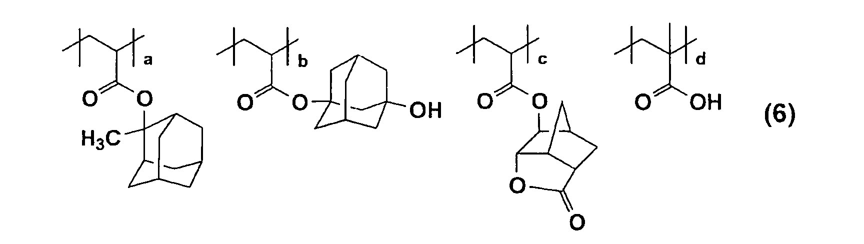

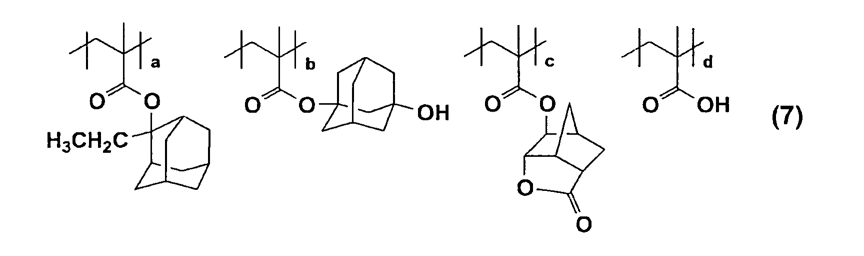

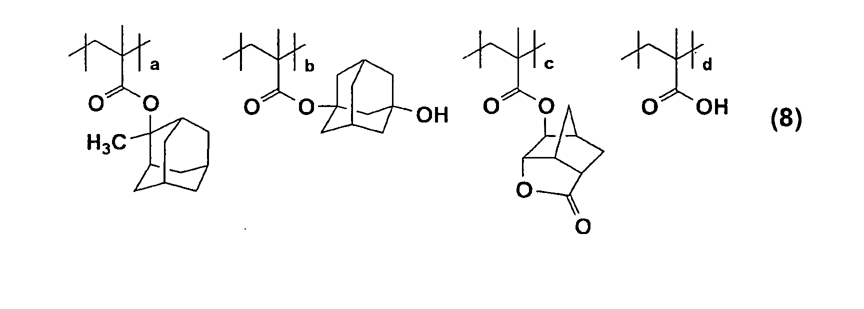

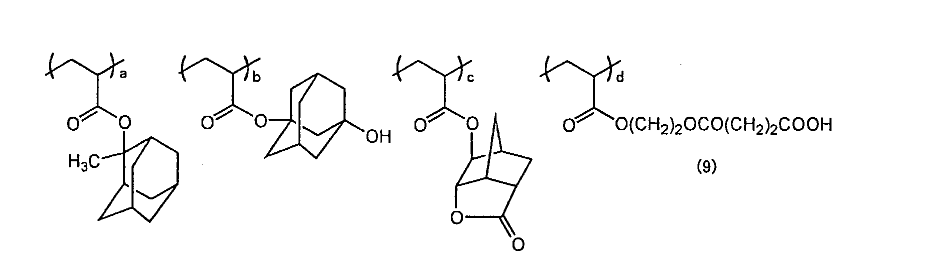

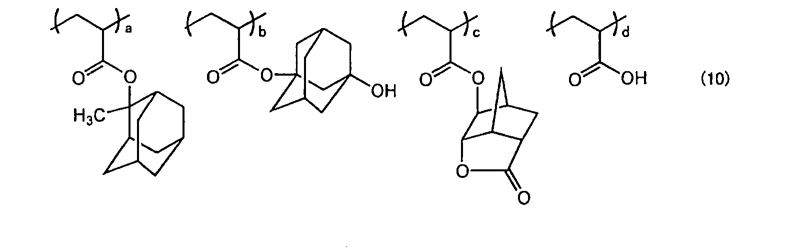

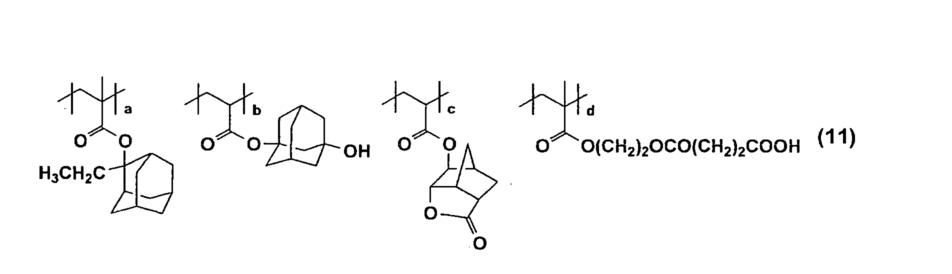

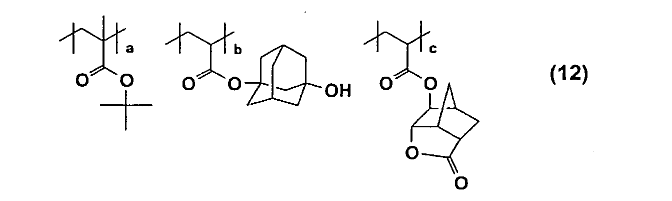

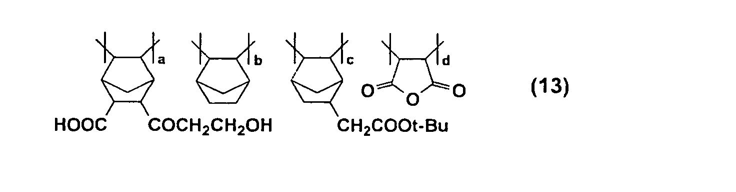

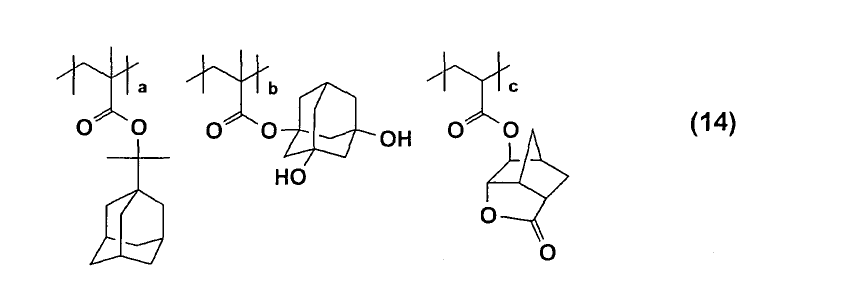

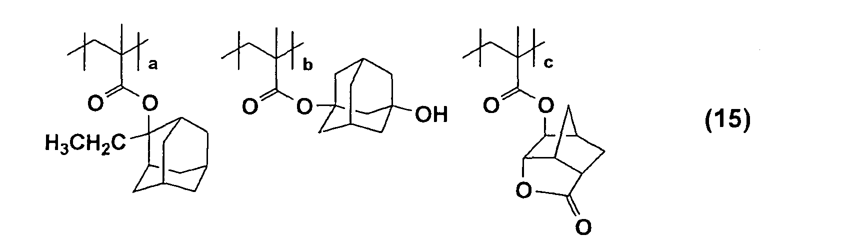

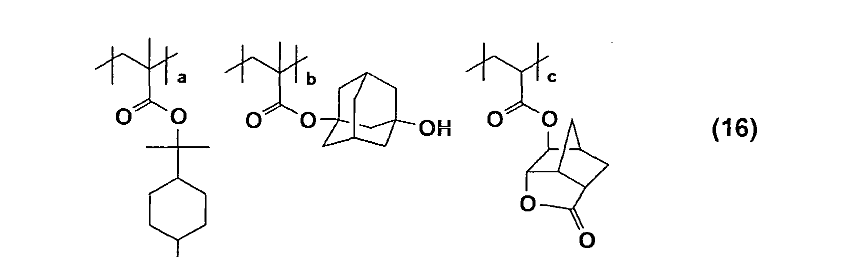

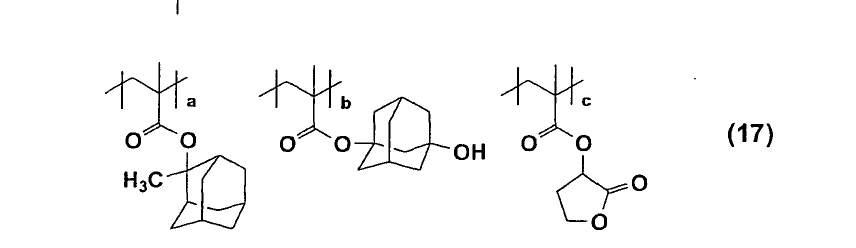

Table 1 shows composition, molecular weight and degree of dispersion of the resins (1) to (17).

**[Table 1]**

| Resin | Composition ratio | | | | Molecular weight | Degree of dispersion |
|---|---|---|---|---|---|---|
| | a | b | c | d | | |
| (1) | 31 | 20 | 39 | 10 | 8010 | 2.1 |
| (2) | 21 | 19 | 41 | 19 | 7050 | 2.3 |
| (3) | 28 | 21 | 40 | 11 | 8900 | 1.6 |
| (4) | 23 | 18 | 39 | 20 | 10100 | 2.5 |
| (5) | 33 | 28 | 30 | 9 | 15020 | 1.9 |
| (6) | 35 | 35 | 19 | 11 | 5070 | 1.8 |
| (7) | 32 | 35 | 18 | 15 | 8070 | 2.2 |
| (8) | 21 | 30 | 34 | 15 | 6600 | 1.9 |
| (9) | 25 | 35 | 30 | 10 | 8930 | 2.6 |
| (10) | 28 | 33 | 25 | 14 | 7700 | 1.6 |
| (11) | 34 | 34 | 25 | 7 | 6090 | 1.6 |
| (12) | 35 | 32 | 33 | - | 8010 | 1.9 |
| (13) | 9 | 19 | 33 | 39 | 11250 | 2.3 |
| (14) | 31 | 21 | 48 | - | 7600 | 1.9 |
| (15) | 30 | 35 | 35 | - | 9200 | 2.1 |
| (16) | 31 | 39 | 30 | - | 1100 | 2.2 |
| (17) | 35 | 36 | 29 | - | 5800 | 2.5 |

### Synthesis Example 2 (synthesis of compound (I)-1)

In a tetrahydrofuran solution of a Grignard reagent, prepared by an ordinary method from 31.3 g (0.075 mol) of 4-nonafluorobutylbromobenzene, 6.1 g (0.03 mol) of diphenylsulfoxide were added, then 8.1 g (0.075 mol) of trimethylsilyl chloride were dropwise added at 0 to 30°C and the mixture was agitated for 3 hours. After the reaction, the obtained reaction liquid was poured into 100 ml of 12% hydrobromic acid, then was washed with 75 ml of toluene and extracted three times with 75 ml of dichloromethane. The obtained product was concentrated and dried, and crystallized by adding 100 ml of ethyl acetate, to obtain 7.5 g of 4-nonafluorobutylphenyl diphenyl sulfonium bromide.

5.6 g (0.01 mol) of the obtained 4-nonafluorobutylphenyl diphenyl sulfonium bromide were dissolved in 50 ml of methanol, and, after an addition of 2.3 g (0.01 mol) of silver oxide, agitated for 2 hours at the room temperature. The obtained silver salt was separated by filtering, and, after an addition of 3.0 g (0.01 mol) of nonafluorobutanesulfonic acid, agitated for 1 hour at the room temperature. The obtained crude product was concentrated and dried, and crystallized by adding 100 ml of n-hexane to obtain 7.60 g of a compound (I)-1.

Other compounds (I) were obtained a method similar to the synthesis example 2.

### Examples 1 to 15 and Comparative Examples 1 to 3

### (Preparation and evaluation of positive resist composition)

Resin 1.03 g
Photo-acid generator 0.00035 mol.
Nitrogen-containing basic compound 1.65 mg, and
Surfactant 100 ppm in the entire amount were blended as shown in Table 2, then dissolved in a solvent shown in Table 2 so as to obtain a solid of 11 % by weight, and filtered with a filter of 0.1 µm to obtain positive resist compositions of Examples 1 to 15 and Comparative Examples 1 to 3.

**[Table 2]**

| | Resin | Photo-acid generator (mol ratio) | Nitrogen-containing compound | Solvent (weight ratio) | Surfactant | Curvature reproducibility (nm) | Resolution (nm) | Initial particles (count) | Profile | Sensitivity (mJ/cm²) |
|---|---|---|---|---|---|---|---|---|---|---|
| Ex.1 | (1) | (I)-2/ (II)-1 =4/1 | N-1 | S-1/S-5 (3/2) | W-1 | 50 | 100 | <50 | + | 25.0 |
| Ex.2 | (3) | (I)-20/ (II)-20 =2/3 | N-2 | S-1/S-5 (3/2) | W-1 | 50 | 105 | <50 | + | 20.5 |
| Ex.3 | (4) | (I)-36/ (II)-2 =3/2 | N-3 | S-1/S-10 (3/2) | W-1 | 65 | 110 | <50 | + | 23.5 |
| Ex.4 | (1) | (I)-44/ (II)-1 =4/1 | N-1 | S-1/S-5 (3/2) | W-1 | 50 | 100 | <50 | + | 25.5 |
| Ex.5 | (3) | (I)-2 | N-2 | S-1/S-5 (3/2) | W-1 | 60 | 105 | <50 | + | 35.0 |
| Ex.6 | (5) | (I)-5 | N-4 | S-1/S-5 /S-2 (3/1/3) | W-1 | 60 | 120 | <50 | + | 35.0 |
| Ex.7 | (7) | (I)-9 | N-5 | S-1/S-5 (3/2) | W-1 | 65 | 120 | <50 | + | 35.5 |
| Ex.8 | (8) | (I)-13 | N-6 | S-5 | W-2 | 60 | 120 | 100 | + | 36.0 |
| Ex.9 | (9) | (I)-22 | N-7 | S-1/S-10 (2/3) | W-2 | 60 | 120 | <50 | + | 38.5 |
| Ex.10 | (12) | (I)-31 | N-5 | S-1/S-2 (2/3) | W-1 | 65 | 120 | <50 | ± | 36.5 |
| Ex.11 | (13) | (I)-20 | N-1 | S-1 | - | 75 | 130 | 150 | ± | 34.5 |
| Ex.12 | (14) | (I)-35 | N-7 | S-1/S-9 (20/1) | W-2 | 65 | 125 | <50 | + | 37.5 |
| Ex.13 | (15) | (I)-37 | N-7 | S-1/S-9 (20/1) | W-2 | 65 | 125 | <50 | + | 37.5 |
| Ex.14 | (16) | (I)-31 | N-7 | S-1/S-7 (20/1) | W-2 | 70 | 130 | <50 | + | 38.0 |
| Ex.15 | (17) | (I)-35 | N-7 | S-1 | W-2 | 65 | 125 | 150 | + | 37.0 |
| Camp. Ex.1 | (17) | (I)-35 | - | S-1 | W-1 | 210 | 145 | 250 | ± | 34.5 |
| Comp. Ex.2 | (16) | (II)-1 | N-7 | S-1 | W-1 | 180 | 140 | 1050 | ± | 36.5 |
| Comp. Ex.3 | (13) | (II)-1 | - | S-1 | W-1 | 250 | 145 | 1200 | - | 24.0 |

In the table, nitrogen-containing basic compounds are:
N-1: 1,5-diazabicyclo[4.3.0]-5-nonene
N-2: 1,8-diazabicyclo[5.4.0]-7-undecene
N-3: 4-dimethylaminopyridine
N-4: triphenylimidazole
N-5: diisopropylamine
N-6: tributylamine
N-7: trioctylamine.

The surfactants are:
W-1: Megafac F176 (manufactured by Dainippon Inks and Chemicals, Inc.) (containing fluorine)
W-2 : Megafac R08 (manufactured by Dainippon Inks and Chemicals, Inc.) (containing fluorine and silicon).
Solvents are:
S-1: propylene glycol monomethyl ether acetate
S-2: ethyl lactate
S-3: butyl acetate
S-4: 2-heptanone
S-5: propylene glycol monomethyl ether
S-6: ethyl ethoxypropionate
S-7: γ-butyrolactone
S-8: ethylene carbonate
S-9: propylene carbonate
S-10: cyclohexanone.

### <Evaluation of sensitivity and resolution>

On a silicon wafer treated with hexamethyl disilazane, ARC 29a, manufactured by Brewer Science Inc., was uniformly coated with a thickness of 780 angstroms with a spin coater, dried for 90 seconds at 100°C on a hot plate, and heated for 60 seconds at 205°C to obtain an antireflection film. Then each positive resist composition, immediately after the preparation, was coated with a spin coater and heated for 90 seconds at 120°C to obtain a resist film of 0.30 µm.

The resist film was exposed in anArF excimer laser stepper (ISI Ltd., NA = 0.6) through a mask, and, immediately after the exposure, heated for 90 seconds at 120°C on a hot plate. It was then developed for 60 seconds at 23°C with a 2.38 % by weight aqueous solution of tetramethylammonium hydroxide, rinsed for 30 seconds with deionized water and dried to obtain a resist line pattern.

A sensitivity was represented by an exposure amount (mJ/cm²) reproducing a line-and-space (1/1) pattern of 0.15 µm.

Also a resolution was represented by a minimum dimension (µm) of a resist pattern resolved in such exposure amount.

### <Evaluation of profile>

A cross section of a line pattern of 0.15 µm, obtained at a minimum exposure amount capable of reproducing a 0.15 µm line pattern on the mask, was observed under a scanning electron microscope. A rectangular shape was represented by +, a round top shape was represented by -, and a somewhat round top shape was represented by ±.

### <Evaluation of initial particle count>

In each positive resist composition, particles in the liquid immediately after preparation were counted by a Rion particle counter.

### <Evaluation of curvature reproducibility>

A radius of curvature was determined in a 90°-flexed portion of an obtained pattern (pattern size = 0.20 µm) by an observation with a scanning electron microscope, from above the wafer.

Results of evaluations are shown in Table 2.

Table 2 indicates that the positive resist composition of the present invention has a high sensitivity, a high resolution, a rectangular profile, a low initial particle count and an excellent curvature reproducibility.

The present invention allows to provide a positive resist composition having a high sensitivity, a high resolution a rectangular profile, and a low initial particle level, and is excellent in a curvature reproducibility, and a pattern forming method using such positive resist composition.

The entire disclosure of each and every foreign patent application from which the benefit of foreign priority has been claimed in the present application is incorporated herein by reference, as if fully set forth.

## Claims

1. A positive resist composition comprising:
(A) a resin which increases a solubility of the resin (A) in an alkali developer by an action of an acid;
(B-1) a triarylsulfonium salt having a fluorine atom in a cation part of the triarylsulfonium salt, wherein the triarylsulfonium salt generates one of: an aliphatic sulfonic acid having a fluorine atom; and an aromatic sulfonic acid having a fluorine atom upon irradiation with one of an actinic ray and a radiation;
(C) a nitrogen-containing basic compound; and
(D) an organic solvent.

2. The positive resist composition of claim 1,
wherein the organic solvent (D) comprises:
at least one selected from the group A consisting of propylene glycol monoalkyl ether carboxylate; and
at least one of: at least one selected from the group B consisting of propylene glycol monoalkyl ether, alkyl lactate and alkyl alkoxypropionate; and at least one selected from the group C consisting of γ-butyrolactone, ethylene carbonate, propylene carbonate and cyclohexanone.

3. The positive resist composition of claim 1, further comprising (B-2) a sulfonium salt not having a fluorine atom in a cation part of the sulfonium salt, wherein the sulfonium salt generates one of: an aliphatic sulfonic acid having a fluorine atom; and an aromatic sulfonic acid having a fluorine atom upon irradiation with one of an actinic ray and a radiation.

4. The positive resist composition of claim 1,
wherein the resin (A) comprises at least one alicyclic hydrocarbon structure having at least one of a monocyclic group and a polycyclic group.

5. A pattern forming method comprising:
forming a resist film with a positive resist composition according to claim 1;
exposing the resist film, so as to form an exposed resist film; and
developing the exposed resist film.

6. The positive resist composition of claim 1,
wherein the triarylsulfonium salt (B-1) is represented by a general formula (BI): 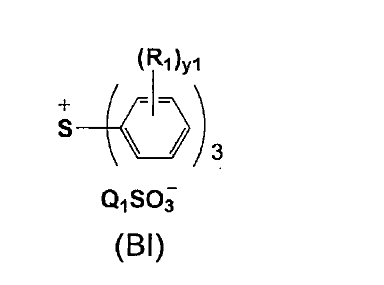 in which R₁ represents an alkyl group, an alicyclic hydrocarbon group, a hydroxyl group, a carboxyl group, an alkoxy group, a halogen atom or a phenylthio group, and, in case R₁ is present in plural units, R₁'s are mutually same or different; and at least one of R₁'s represents a fluorine atom, a fluorine-containing alkyl group, a fluorine-containing alicyclic hydrocarbon group, a fluorine-containing alkoxy group or a fluorine-containing phenylthio group;
y1's each independently represents 0 to 5; and
Q₁ represents a fluorine-containing alkyl group, a fluorine-containing cycloalkyl group, a fluorine-containing aryl group or a fluorinated alkyl group-containing aryl group.

7. The positive resist composition of claim 3,
wherein the sulfonium salt (B-2) is represented by one of a general formula (BII) and (BIII): 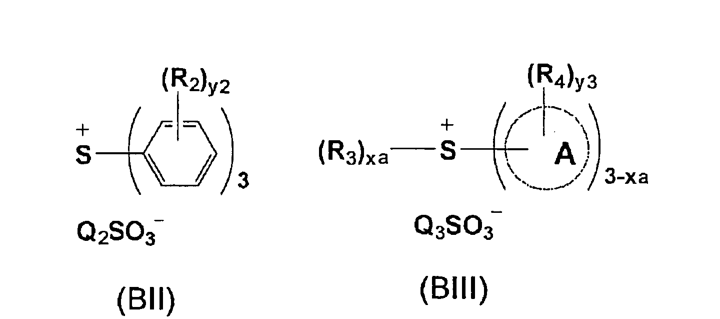 In which R₂ represents an alkyl group, an alicyclic hydrocarbon group, a hydroxyl group, a carboxyl group or an alkoxy group, and in case R₂ is present in plural units, R₂'s are mutually same or different;
Q₂ represents a fluorine-containing alkyl group, a fluorine-containing cycloalkyl group, a fluorine-containing aryl group or a fluorinated alkyl group-containing aryl group;
y2's each independently represents 0 to 5;
R₃ represents an alkyl group or an alicyclic hydrocarbon group, also in case R3 ispresent inplural units, R₃'s are mutually same or different, and in case R₃ is present in plural units, R₃'s may be mutually bonded to form a ring;
R₄ represents an alkyl group, an alicyclic hydrocarbon group, a hydroxyl group, a carboxyl group or an alkoxy group, and in case R₄ is present in plural units, R₄'s are mutually same or different;
A represents an aromatic group or a heterocyclic group;
Q₃ represents a fluorine-containing alkyl group, a fluorine-containing cycloalkyl group, a fluorine-containing aryl group or a fluorinated alkyl group-containing aryl group;
Xa represents 1 to 3; and
y3's each independently represents 0 to 5.

8. The positive resist composition of claim 4,
wherein the resin (A) further comprises a unit having a group where an alkali-soluble group is protected with one of a 2-alkyl-2-adamantyl group and a 1-adamantyl-1-alkylalkyl group.

9. The positive resist composition of claim 4,
wherein at least one of said at least one alicyclic hydrocarbon structure comprised in the resin (A) is a dihydroxyadamantane.

10. The positive resist composition of claim 1,
wherein the resin (A) comprises four units (A-1) to (A-4) :
(A-1) at least one selected from a unit represented by a general formula (I): 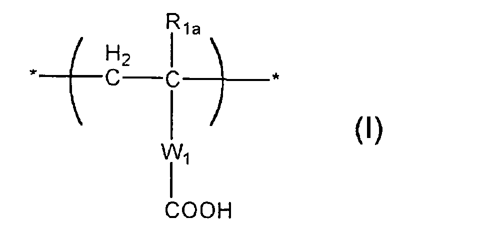 in which R₁ₐ represents a hydrogen atom or a methyl group; and
W₁ represents a single bond or a divalent connecting group;
(A-2) at least one selected from a unit having one of a group represented by general formulas (II-1) to (II-4): 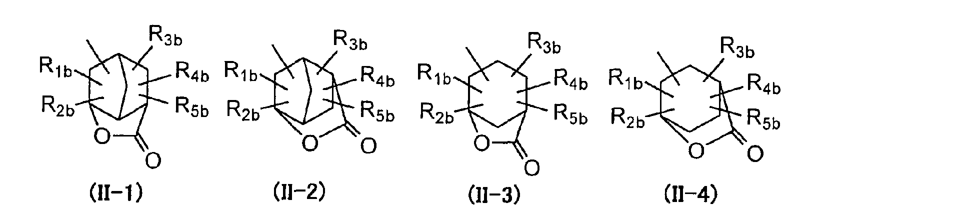 in which R_{1b} to R_{5b} each independently represents a hydrogen atom, an alkyl group, a cycloalkyl group or an alkenyl group, and two among R_{1b} to R_{5b} may be mutually bonded to form a ring;
(A-3) at least one selected from a unit represented by a general formula (III): 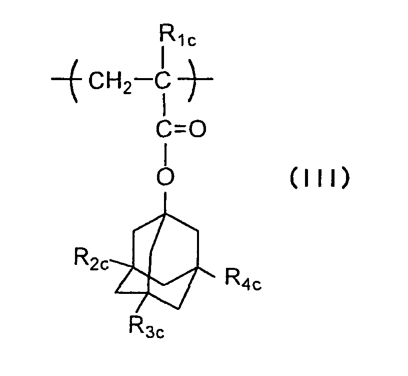 in which R_{1c} represents a hydrogen atom or a methyl group; and
R_{2c} to R_{4c} each independently represents a hydrogen atom or a hydroxyl group, and at least one of R_{2c} to R_{4c} represents a hydroxyl group; and
(A-4) at least one selected from a unit having a group where an alkali-soluble group is protected with one of a 2-alkyl-2-adamantyl group and a 1-adamantyl-1-alkylalkyl group.
